(19) Europäisches Patentamt
European Patent Office
Office européen des brevets

(11) **EP 3 857 309 B1**

(12) **EUROPEAN PATENT SPECIFICATION**

(45) Date of publication and mention
of the grant of the patent:
**04.01.2023 Bulletin 2023/01**

(21) Application number: **19782499.8**

(22) Date of filing: **24.09.2019**

(51) International Patent Classification (IPC):
**G03F 7/20** *(2006.01)*   **B29C 64/393** *(2017.01)*
**B33Y 10/00** *(2015.01)*   **B33Y 30/00** *(2015.01)*

(52) Cooperative Patent Classification (CPC):
**G03F 7/70416; B29C 64/393; B33Y 10/00;
B33Y 30/00**

(86) International application number:
**PCT/EP2019/075772**

(87) International publication number:
**WO 2020/064779 (02.04.2020 Gazette 2020/14)**

(54) **CONTROLLED POLYMERIZATION OF A TARGET ZONE IN A PHOTOPOLYMERIZABLE MEDIUM**

KONTROLLIERTE POLYMERISATION VON EINEM ZIELBEREICH IN EINEM
FOTOPOLYMERISIERBAREN MEDIUM

POLYMÉRISATION CONTRÔLÉE D'UNE ZONE CIBLE DANS UN MILIEU PHOTOPOLYMÉRISABLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.09.2018 EP 18196384**

(43) Date of publication of application:
**04.08.2021 Bulletin 2021/31**

(73) Proprietor: **Stichting Nederlandse
Wetenschappelijk
3527 JP Utrecht (NL)**

(72) Inventor: **KOSTENKO, Alexander
3527 JP Utrecht (NL)**

(74) Representative: **De Vries & Metman
Overschiestraat 180
1062 XK Amsterdam (NL)**

(56) References cited:
**US-A1- 2012 092 632      US-A1- 2018 086 007
US-A1- 2018 153 205**

- **MAXIM SHUSTEFF ET AL: "One-step volumetric
additive manufacturing of complex polymer
structures", SCIENCE ADVANCES, vol. 3, no. 12,
8 December 2017 (2017-12-08), page eaao5496,
XP055468403, DOI: 10.1126/sciadv.aao5496 cited
in the application**
- **Brett Kelly ET AL: "Computed Axial Lithography
(CAL): Toward Single Step 3D Printing of
Arbitrary Geometries", , 16 May 2017
(2017-05-16), XP055531615, Retrieved from the
Internet:
URL:https://arxiv.org/pdf/1705.05893.pdf
[retrieved on 2019-03-15]**

## Description

Field of the invention

The invention relates to controlled polymerization of a target zone in a photopolymerizable medium, and, in particular, though not exclusively, to methods and systems for determining an illumination intensity for polymerization of a target zone in a photopolymerizable medium and to methods and systems for forming a three-dimensional object by controlled polymerization of a target zone in a photopolymerizable medium and to computer program products using such methods.

Background of the invention

During past decades, a large number of techniques were developed for the generation of solid three-dimensional structures from liquid polymerizable media (photocurable resins). The underlying process involving a photocurable resin that can be polymerized when illuminated by electromagnetic radiation (typically ultra-violet, visible or infra-red light) is referred to as optical- or photolithography. Developments in the field of highresolution photolithography include Resolution Augmentation through Photoinduced Deactivation (RAPID), PhotoInhibited Super Resolution (PInSR) and multi-colour photolithography.

A number of approaches were developed for production of three-dimensional objects, including the standard stereo lithography or variations thereof, such as Projection Stereo Lithography (PSL) and Continuous liquid interface printing (CLIP). In these techniques, three-dimensional structures are fabricated through sequential generation of thin two-dimensional layers. Techniques that allow initiation of the photopolymerization reaction in the volume instead of a layer-by-layer process were, so far, limited to holographic lithography and multiphoton polymerization - approaches that are suitable for generation of structures and patterns on a microscopic scale. Implementation of volumetric printing was proposed more than three decades ago, however, actual realizations of techniques that allow volumetric fabrication at macroscopic scale were only recently achieved.

For example, Shusteff1 et. al, describe in their article One-step volumetric additive manufacturing of complex polymer structures, Science Advances 8 Dec 2017, vol. 3, no. 12, a triple-beam holographic illumination technique enabling realization of macroscopic but relatively small ($\approx$ 1 cm), three-dimensional structures. Similarly, Brett E. Kelly et. al, in their article Computed Axial Lithography (CAL): Toward Single Step 3D Printing of Arbitrary Geometries, arXiv, May 2017, demonstrated a volumetric printing approach based on the algorithms and principles used in Computed Tomography. Authors acknowledged the fact that the methods used in Computed Tomography require projection of negative intensity field in order to create an arbitrary 3D shape. Since this cannot be achieved in a physical system, they proposed a workaround that allows to find an approximate solution and print an arbitrary 3D shape with some loss of definition. However, accurate formation of a holographic image in a medium of certain properties (e.g. diffusion rates and concentrations of the reactive components) is a non-trivial exercise thereby limiting the maximum size, complexity and the spatial resolution of the produced object. Furthermore, U.S. Patent Application number 2018086007 discloses a method for performing a 3D printing process involving: directing a primary light beam toward a photoresin to initiate polymerization of select areas of the photoresin and a secondary light beam having a different wavelength to control polymerization inhibition of additional areas bordering the select areas.

Hence, from the above it follows that there is a need in the art for improved methods and systems that enable the formation of three dimensional objects of considerably size based on controlled 3D exposure of a photopolymerization medium.

Summary of the invention

It is an objective of the invention to reduce or eliminate at least one of the drawbacks known in the prior art. The invention allows relaxation of resolution and size constraints as well as shape complexity constraints of current prior art systems for forming a complex 3D object based by controlled illumination of a photopolymerizable medium.

The methods and systems of the embodiments described in this application allow formation of an arbitrarily shaped polymer object of macroscopic dimensions, by means of a highly multi-directional illumination system (involving hundreds to thousands of directions of illumination) through controllable full-field illumination of the volume of the photopolymerizable medium. The system may include a computer for receiving a 3D data representation configured to compute an optimal direction-dependent illumination field that upon incidence on the volume of the photopolymerizable medium leads to formation of a polymerized solid object within the boundaries of the target polymerization zone.

The invention relates to a method of controlled polymerization of a target zone in a photopolymerizable medium as defined in claim 1 or claim 9 and to an exposure system adapted to photopolymerize a target zone in a photopolymerizable medium as defined in claim 10.

In an embodiment, the model of the polymerization process may be based on a polymerization model $\mathcal{P}[E_0] = \mathcal{P}_0$ , where $\mathcal{P}_0$ is the target monomer conversion in each volume element. In an embodiment, the polymerization model $\mathcal{P}[E]$ may be a based on a reactive molecular dynamics modelling. Such modelling is for example described in the article by Torres-Knoop, A, et al. Soft matter 14.17 (2018): 3404-3414.

In another embodiment, the polymerization model P[E] may be a based on a dynamic random graph technique, which is an analytical approximation of the reactive molecular dynamics. This technique is described in two articles by Kryven, I. Phys. Rev. E 94.1 (2016): 012315 and Kryven, I. J Math Chem (2018) 56: 140.

The monomer conversion is defined as ratio between the number of formed covalent bonds and the maximum possible number of such bonds in a volume element. The monomer conversion can be directly translated into a gel fraction as described in the above-mentioned article by Torres-Knoop and the second article by Kryven. This gel fraction characterizes the so-called hardness of the cured resin in each volume element.

An illuminated volume element becomes solid as soon as the monomer conversion described by the polymerization model $\mathcal{P}[E]$ reaches a certain critical value $\mathcal{P}_{crit}$ . The target deposited energy is determined such that $\mathcal{P}[E_0] > \mathcal{P}_{crit}$ inside the target polymerization zone and $\mathcal{P}[E_0] \ll \mathcal{P}_{crit}$ outside the target polymerization zone. In some of the examples in this disclosure an approximation is used wherein $\mathcal{P}[E]$ is expressed by a linear combination of $E_+$ and $E_-$ (see e.g. equation 8 below). It is noted however, that the embodiments in this application are not limited to these examples.

Thus, the polymerization model $\mathcal{P}$ may be based on reaction rate equations, a reactive force field approach, a random graph approach or a (linearized) approximation of these models. In an embodiment, $E_0$ may be determined based on the polymerization model $\mathcal{P}[E_0] = \mathcal{P}_0$ . In an embodiment, the polymerization model may be approximated by a linear inequality where $E_0 \geq E_{crit}$ inside the target zone and $E_0 < E_{crit}$ outside of the target zone.

In an embodiment, the polymerization model P[E] may describe monomer conversion as a linear function of energy of type $\mathcal{P} = \alpha E$ . In another embodiment, it may describe monomer conversion as a non-linear expression, for instance, a sigmoid function of the type:

$$\mathcal{P} = \frac{1}{1 + e^{E_{crit} - E}}$$

Such sigmoid function may be advantageous for constructing an iterative optimization algorithm, where deposition of energies higher than some critical value $E_{crit}$ still leads to a desirable solution. In the linear approach, polymerization is considered to be reached when the deposited energy E equals to a critical value $E_{crit}$. In a further embodiment, the medium may comprise multiple photosensitive components. In such embodiment, the polymerization model may be defined as a linear combination of energies absorbed by each component: $\mathcal{P} = E_+ - \beta E_-$ and the target conversion $\mathcal{P}_0$ can be replaced by a target energy $E_0$.

A light propagation model $\mathcal{M}$ (of any suitable type, linear of non-linear) that models the deposited energy field E generated upon exposure of the medium to a direction-dependent illumination field *I* during time *t,* may be used to compute an optimal illumination field $I_0$. Such computation may be based on minimization of a difference (or any algorithm based on minimization or maximization of a relevant objective function) between the deposited energy field *E* and the target energy field $E_0$ (where the target energy field $E_0$ may be determined statically or dynamically during the exposure of the medium). This light propagation model $\mathcal{M}$ may hereafter referred to as

$$\mathcal{M}[I_o].$$

In an embodiment, the light propagation model

$$\mathcal{M}[I_o]$$

may be implemented using at least one of: Radiative Transport Equations, a Monte Carlo technique or a Radon transform.

Hence, the target energy field $E_0$ may be used by the processor to determine a direction-dependent illumination field $I_0$ and an exposure time t for each wavelength and each direction of illumination achievable within the illumination system. The illumination intensity and the exposure time may be selected to sustain and control the polymerization reaction within an accurately defined target zone that is shaped according to the 3D model. The processor may use the direction-dependent illumination intensities and exposure times (for each wavelength) to control a rotatable and/or movable illumination system so that in the target zone an object is formed through photopolymerization that matches the 3D model defined by the 3D data representation.

The processor may determine a solution of the illumination intensity based on a model wherein the energy deposition is described in a weakly attenuating medium. In particular, in an embodiment, a solution of the illumination intensity based on a model wherein the polymerization is approximated by a linear inequality, and the energy deposition is described for a weakly attenuating medium. For a weakly attenuating medium, the solution may be computed analytically. Alternatively, an iterative solver may be used to determine a solution using a model wherein energy deposition is described for a significantly attenuating medium and/or wherein the polymerization model may have a non-linear form.

In an embodiment, the computing may further include: determining a solution $I_o$ for a system of equations of the type

$$E_0 = t \cdot \mathcal{M}[I_o].$$

In an embodiment, the light propagation model $\mathcal{M}$ being a model for predicting the deposited energy field E in a weakly attenuating medium.

In an embodiment, the computing may further include: iteratively determining an approximate solution $I_o$ based on the light propagation model

$$\mathcal{M}[I_o],$$

the computing including minimizing a difference between the target energy field $E_0$ and a deposited energy field E predicted by the light propagation model

$$\mathcal{M}[I_o].$$

In an embodiment, the computing may further include: iteratively computing an approximate solution $I_0$ based on a (non-linear) polymerization model $\mathcal{P}[E]$ and a light propagation model

$$\mathcal{M}[I_0].$$

The computing may include minimizing a difference between the target monomer conversion $\mathcal{P}_0$ and a monomer conversion P[E] achieved due to the deposited energy field E predicted by the light propagation model

$$\mathcal{M}[I_0].$$

In an embodiment, the light propagation model $\mathcal{M}$ may be a model for predicting the deposited energy field E in an attenuating medium.

In an embodiment, the medium may include a photo-activation compound, preferably a photo-initiator and, optionally, a photosensitizer, for activating polymerization of the medium and a photo-deactivation compound, preferably a photo-inhibitor and, optionally, a photosensitizer, for deactivating polymerization in the medium.

In an embodiment, the computing a direction-dependent optimal illumination field $I_o$ may further include: computing at least a first illumination field $I_+$ associated with a first wavelength and a second illumination field $I_-$ associated with a second wavelength, the second wavelength being different from the first wavelength, the first illumination field $I_+$ being configured to deposit within an exposure time t a first deposited energy $E_+$ in the volume elements of the medium for activating and maintaining polymerization in at least part of the target zone and the second illumination field $I\_$ being configured to deposit within an exposure time t a second deposited energy $E\_$ in the volume elements of the medium for deactivation of polymerization in at least part of the target zone.

In case multiple photosensitive components are present in the medium, the target energy field may describe a linear combination of energies absorbed by each individual photosensitive component, provided that the given linear combination leads to initiation and sufficient advance of the polymerization reaction within the boundaries of the target zone and sufficient inhibition or deactivation of the polymerization reaction outside of the boundaries of the target zone.

In an embodiment, the analytical solution may include a Fourier filter applied to the Radon transform of the target deposited energy:

$$I_o = \frac{1}{\mu_+ t} \mathcal{F}\mathcal{R}[E_0].$$

In an embodiment, the system for illuminating a target zone may comprise a container enclosing a photopolymerizable medium and a rotatable and/or movable illumination system, the illumination system including an optical system comprising light sources and optical elements, a light modulating aperture and a support structure including motors and/or actuators configured to rotate and/or move the illumination system around the container while locally exposing the medium to light of at least one predetermined wavelength.

In an embodiment, the generating a plurality of direction-dependent illumination beams may include: the processor controlling a rotatable and/or movable illumination system, the illumination system including at least one pixelated spatial light modulator for generating the plurality of direction-dependent illumination beams. Alternatively, in another embodiment, the plurality of direction-dependent illumination beams may be generated using one or more laser galvanometer scanners (GS). GS technology may have a contrast advantage over SLM by generating beams of high power in directions where it is needed, instead of blocking the light in the directions where low intensity is required.

In an embodiment, the method may further comprise: the processor controlling a detection system to measure the intensity of a part of the plurality of illumination beams that was not absorbed by the medium, preferably the processor using the intensity of the part of the plurality of illumination beams that was not absorbed to compute the absorptivity of the medium $\mu$ during exposure.

In an embodiment, the method may further comprise: recomputing the direction-dependent optimal illumination field $I_o$ based on the target energy field $E_0$, the light propagation model $\mathcal{M}$ and the computed absorptivity $\mu$ of the medium; and, the processor controlling the exposure system based on the recomputed optimal direction-dependent illumination field $I_o$.

In an aspect, the invention may relate to a method of controlled polymerization of a target zone in a photopolymerizable medium. In an embodiment, the method may comprise: a processor connectable to an exposure system for illuminating a target zone in a photopolymerizable medium receiving a 3D data representation of a 3D model of an object and using the 3D model to determine a volume of the target zone, the volume being shaped according to the 3D model; the processor determining a target energy field $E_0$ defining an energy to be absorbed by volume elements in the medium to achieve polymerization inside the target zone, the determining being based on a model of the polymerization process in the medium $\mathcal{P}[E_0] = \mathcal{P}_0$; the processor using the target energy field $E_0$ and a light propagation model $\mathcal{M}$ for a weakly attenuating medium to compute a solution $I_o$, preferably an analytical, for the system of equations of the type:

$$E_0 = t \cdot \mathcal{M}[I_0],$$

wherein $I_o$ is a direction-dependent illumination field needed for achieving energy deposition in the medium according to the target energy field $E_0$ and t is the exposure time; and, the processor controlling the exposure system based on the direction-dependent illumination field $I_o$, the exposure including generating a plurality of direction-dependent illumination beams to deposit energy within the volume of the medium according to the target energy field $E_0$.

In another aspect, the invention may relate to a method of controlled polymerization of a target zone in a photopolymerizable medium wherein the method comprises one or more of the following steps: a processor connectable to an exposure system for illuminating a target zone in a photopolymerizable medium receiving a 3D data representation of a 3D model of an object and using the 3D model to determine a volume of the target zone, the volume being shaped according to the 3D model, the computer determining a target energy field $E_0$ defining an energy to absorbed by volume elements in the medium that is needed to achieve polymerization inside the target zone; the processor using the target energy field $E_0$ and a light propagation model $\mathcal{M}$ for an attenuating medium to iteratively compute an approximate solution $I_o$ for a system of equations of the type: $E_0 =$

$$t \cdot \mathcal{M}[I_o],$$

through minimization of a difference between the target energy field $E_0$ and a deposited energy field E predicted by the light propagation model $\mathcal{M}$; and, the computer controlling the exposure system based on the direction-dependent illumination field $I_o$, the exposure including generating a plurality of direction-dependent illumination beams to deposit energy within the target zone according to the target energy field $E_0$.

In yet another aspect, the invention may relate to a method of controlled polymerization of a target zone in a photopolymerizable medium comprising: a processor connectable to an exposure system for illuminating a target zone in a photopolymerizable medium receiving a data representation of a 3D model of an object and using the 3D model to determine volume elements of the target zone, the photopolymerizable medium including a photo-activation compound for activating polymerization of the medium based on a first illumination field $I_+$ of a first wavelength and a photo-deactivation compound for deactivating the polymerization in the medium based on a second illumination field $I_-$ of a second wavelength; the processor determining a target energy field $E_0$, the target energy field $E_0$ defining an energy to be absorbed by the volume elements of of the target zone to achieve polymerization inside the target zone, the determining by the processor being based on a polymerization model $\mathcal{P}$ of the polymerization process in the medium; the processor computing a direction-dependent illumination field $I_o$ for depositing within an exposure time $t$ the target energy field $E_0$ in the volume elements of the medium, the computing of $I_o$ including using a light propagation model $\mathcal{M}$ for an attenuating medium to compute the first illumination field $I_+$ for depositing within the exposure time t a first deposited energy $E_+$ in the volume elements for activating and maintaining polymerization and the second illumination field $I_-$ for depositing within the exposure time t a second deposited energy $E_-$ in the volume elements for deactivation of the polymerization; the processor controlling the exposure system based on the direction-dependent illumination field $I_o$, the exposure including generating a plurality of direction-dependent illumination beams to deposit energy

In an aspect, the invention may relate to an exposure system adapted to photopolymerize a target zone in a photopolymerizable medium wherein the system may comprise: a computer connectable to a rotatable illumination system for exposing the photopolymerizable medium, the computer comprising a computer readable storage medium having at least part of a program embodied therewith; and a processor, preferably a microprocessor, coupled to the computer readable storage medium, wherein responsive to executing the computer readable program code, the processor is configured to perform executable operations comprising: receiving a 3D data representation of a 3D model of an object and using the 3D model to determine a volume of the target zone, the volume being shaped according to the 3D model; determining a target energy field $E_0$ defining an energy to be absorbed by volume elements of the medium to achieve polymerization inside the target zone, the determining being based model of the polymerization process in the medium; using the target energy field $E_0$ and a light propagation model $\mathcal{M}$ for a weakly attenuating medium to compute an analytical solution $I_o$ for the equation

$$E_0 = t \cdot \mathcal{M}[I_o],$$

wherein $I_o$ is a direction-dependent illumination field needed for achieving energy deposition in the medium according to the target energy field $E_0$ and t is the exposure time; and, controlling the exposure system based on the direction-dependent illumination field $I_o$, the exposure including generating a plurality of direction-dependent illumination beams to deposit energy within the volume of the medium according to the target energy field $E_0$.

In an aspect, the invention may relate to an exposure system adapted to photopolymerize a target zone in a photopolymerizable medium wherein the system may include: a computer connectable to a rotatable illumination system for exposing the photopolymerizable medium, the computer comprising a computer readable storage medium having at least part of a program embodied therewith; and a processor, preferably a microprocessor, coupled to the computer readable storage medium, wherein responsive to executing the computer readable program code, the processor is configured to perform executable operations comprising: receiving a 3D data representation of a 3D model of an object and using the 3D model to determine a volume of the target zone, the volume being shaped according to the 3D model, the computer determining a target energy field $E_0$ defining an energy to be absorbed by volume elements of the medium to achieve polymerization inside the target zone; determining a direction-dependent illumination field $I_o$ needed for achieving energy deposition in the medium according to the target energy field $E_0$, the determining being based on using the target energy field $E_0$ and a light propagation model $\mathcal{M}$ for an attenuating medium to iteratively compute an approximate solution $I_o$ for a system of equations of the type:

$$E_0 = t \cdot \mathcal{M}[I_o],$$

through minimization of a difference between the target energy field $E_0$ and a deposited energy field E predicted by the light propagation model $\mathcal{M}$; and, controlling the exposure system based on the direction-dependent illumination field $I_o$, the exposure including generating a plurality of direction-dependent illumination beams to deposit energy within the target zone according to the target energy field $E_0$.

In an embodiment, the medium may include a photo-activation compound, preferably a photo-initiator and, possibly, a photosensitizer, for activating polymerization of the medium and a photo-deactivation compound, preferably a photo-inhibitor, for deactivating polymerization in the medium, preferably the photo-activation being controlled by an illumination field of a certain wavelength and the photo-deactivation being controlled by an illumination field of a different wavelength.

The invention thus includes methods and systems for rapid three-dimensional fabrication, including a highly multidirectional illumination technique where a large number of illumination beams of variable intensity and are employed to concurrently initiate and/or inhibit a photopolymerization reaction in different parts of the volume of a photocurable resin allowing for an accurate confinement of the photopolymerization reaction within the boundaries of the target three-dimensional polymerization zone.

In order to control the initiation and inhibition of photopolymerization in the volume, more than one independent source of illumination potentially operating at different wavelengths can be used similarly to the multi-color lithography approach or similarly to the photoinduced deactivation approach.

The proposed multidirectional illumination technique may also be used in systems where inhibition of the photopolymerization reaction is not controlled via illumination but is associated with an agent that inhibits photopolymerization at an approximately constant rate in every part of the volume. The method relies on a light propagation model that allows to precompute optimal intensity for each direction of illumination. Such optimization is crucial to achieve correct focusing and deposition of the illumination energy in the volume and to facilitate high definition of the polymerization zone boundary.

The method can be used for rapid generation of an arbitrary three-dimensional solid shape inside a volume of a photopolymerizable medium through deposition of radiation (light) energy within a well-defined three-dimensional polymerization zone.

A polymerization zone with well-defined boundaries is generated due to interaction of the photopolymerizable medium with the illumination field formed by superposition of a large number of illumination beams modulated by light modulating apertures that surround the volume.

A configuration of each light modulating aperture is controlled by an optimization algorithm that finds a solution for the optimal illumination field. Two special cases of such algorithm (analytical and iterative) are described in this document.

The optimization algorithm attempts to solve a mathematical inversion problem for a system of equations that describes transport and deposition of radiation of a given wavelength in a medium with a given properties.

An analytical model may be used to compute a configuration of illumination leading to formation of a target polymerization zone in a medium with negligibly low or weak absorptivity. In case of a medium with medium to significant (substantial) absorptivity, an iterative solver is described that finds an approximate solution for the required illumination configuration.

The computational methods can be applied to different systems, e.g. a conventional photopolymerization system with passive inhibition where the whole volume absorbs some amount of 'background' radiation energy insufficient for complete polymerization due to the presence of inhibitor; while polymerization zone absorbs significantly higher amount of energy that is sufficient for polymerization; a system with active inhibition, where a photopolymerization reaction can be either initiated or inhibited (deactivated) through a controlled deposition of radiation energy inside and outside of the target polymerization zone; or, a system with projection-based illumination, where the illumination beams are considered to follow ray optics laws and systems with holographic illumination where wave properties of light are considered.

The exposure system may comprise an imaging system comprising one or more camera sensors arranged around the reservoir so that the system can image the polymerization process from viewing different angles. Based on these images, the system may determine changes of the medium, e.g. absorptivity or refraction index, during exposure.

In an embodiment, a phase-contrast imaging technique may be used to measure very small variations in absorptivity or refraction index of the medium. The measured changes in the absorptivity or refraction index can be used for real-time correction of the optimal illumination.

In another embodiment, the degree of polymerization determined using spectral measurements of transmitted light using a Fourier-transform infrared spectroscopy (FTIR) tomography method.

In an embodiment, the polymerization may be realized around an existing opaque object. In that case, a real-time computed absorptivity may be used to determine the orientation of the object (and, subsequently, the printed model) and to optimize the intensity field $I_o$ while taking into account the total absorptivity of the build volume.

In an embodiment, the exposure system for illuminating a target zone may further includes a 3D scanning system, wherein the determination of the volume elements of the target zone may comprise: using the 3D scanning system to determine a 3D surface representation of a physical object that is positioned in the medium; aligning an orientation of the 3D model with the orientation of the 3D surface representation; and, using the aligned 3D model and the 3D surface representation to determine the volume elements around the physical object, the volume elements defining the target zone.

Hence, the embodiments described in this application may not only be used for creating a 3D object in the photopolymerizable medium from scratch. In a further embodiment, a 3D object may be printed around or on an existing 3D object. Such object can be introduced into the reservoir prior to the printing process. The presence of the 3D object will alter the total absorptivity of the volume. Hence, in that case, the exposure system may include a 3D scanning mode, wherein the system selects one or more scanning beams of a wavelength that does not affect the photopolymerizable medium. During the scanning process, the surface of the 3D object is scanned using one or more scanning beams and either the reflected or transmitted light of the one or more scanning beams is detected by the imaging system of the system. The imaging system may include one or more camera sensors arranged around the reservoir so that the system is able to detect reflections of the scanning beams from different viewing angles. The captured images may be used to reconstruct the surface of the 3D object in the reservoir.

The computed reconstructed surface of the 3D object may be matched with a known 3D model to determine its orientation. To that end, a known registration method, e.g. a rigid surface registration method, may be used to register the reconstructed surface with the 3D model. This way, the orientation of the target zone can be aligned with orientation of the 3D object in the target zone. The orientation of the target zone and the computed absorptivity $\mu_c(x,y,z)$ may be used to calculate the optimal illumination intensity $I_0(r, \theta, z)$ to deposit around an external object using the methods described in this application.

In further embodiments, the illumination system used for exposing the medium deviate from geometries that are used in standard tomography applications wherein light beams are projected at a 90 degree angle to the rotation axis, e.g. the z-axis. In an embodiment, the illumination system may be rotatable mounted above a reservoir comprising a photopolymerizable medium, wherein the dimensions of the reservoir in the x,y direction (perpendicular to the rotation axis of the illumination system) are substantially larger than the dimensions of the reservoir in the z direction (parallel to the rotation axis). This way, the reservoir may define one or more shallow planar-shaped target zones similar to an illumination system as used in laminography, which is a subtype of tomography.

The illumination system may further comprise one or more optical elements for projecting one or more light beams from the top (or bottom) at a grazing angle $\Theta$ to the flat surface of the reservoir (wherein the angle between the one or more light beams and the rotation axis is smaller than 90 degrees). When rotating, the illumination system exposes the photopolymerizable medium in a target zone in the reservoir.

The invention will be further illustrated with reference to the attached drawings, which schematically will show embodiments according to the invention. It will be understood that the invention is not in any way restricted to these specific embodiments.

Brief description of the drawings

**Fig. 1** depicts a schematic of a system for forming a 3D object using photopolymerization according to an embodiment of the invention;
**Fig. 2** depicts part of a schematic of a system for forming a 3D object using photopolymerization according to an embodiment of the invention;
**Fig. 3A-3E** depict computed energy deposition based on a superposition of multiple illumination beams;
**Fig. 4A-4D** depict computed energy deposition resulting from a superposition of multiple illumination beams that were precomputed and generated according to an analytical model valid for media with low absorptivity;
**Fig. 5** depicts a flow diagram of a part of a method for determining an illumination energy for a target polymerization according to an embodiment of the invention;
**Fig. 6A-6D** depict examples of computed energy deposition for a 3D object based on the low absorptivity model;
**Fig. 7** depicts a flow diagram of a method for determining an illumination energy for a target polymerization zone;
**Fig. 8A-8D** depict examples of computed energy deposition for a 3D object based on the iterative approach;
**Fig. 9** depicts a schematic of a system for forming a 3D object using photopolymerization according to an embodiment of the invention;

**Fig. 10** depicts a schematic of a system for forming a 3D object using photopolymerization;
**Fig. 11** is a block diagram illustrating an exemplary data computing system that may be used for executing methods and software products described in this disclosure.

Detailed description

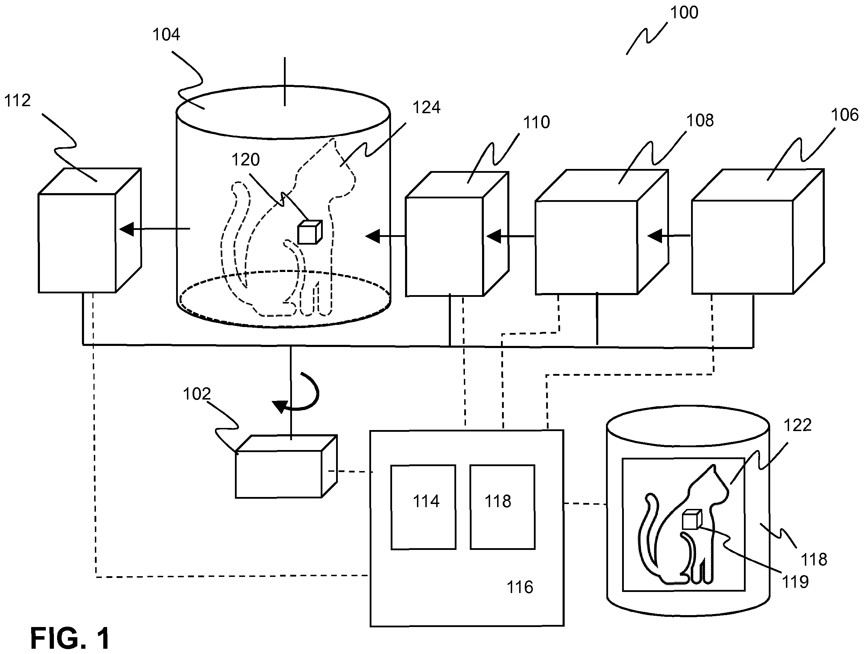

**Fig. 1** depicts a schematic of an exposure system for illumination of a target zone in a photopolymerizable medium (or, in short, a medium) according to an embodiment of the invention. As shown in **Fig.** 1, the system **100,** a 3D photopolymerization system, may comprise a container **104** enclosing a medium of a certain volume and a rotatable and/or movable illumination system, including an optical system comprising light sources **106** and optical elements **108,** light modulating aperture **110** and a support structure including motors and/or actuators **102** configured to rotate and/or move the illumination system around the container at high speed (either around a single axis or multiple axes) while locally exposing the medium to light of at least one predetermined wavelength. This way, the medium is exposed by light beams of predetermined intensities from different angles within a short span of time. In an embodiment, if the properties of the medium allow, the container may be rotated instead or at the same time with the rotatable illumination system.

The exposure system allows controlled exposure of locations in the medium by light of a certain intensity and wavelength may be achieved for locally triggering a photopolymerization process within a predetermined volume of the medium. The volume in which photopolymerization takes place may be referred to as the target polymerization zone or in short the target zone. Further, the total volume of the medium in the container may be referred to as the build volume. During the exposure of the target zone with an illumination beam of a predetermined intensity and wavelength incident from a single direction, a certain amount of the light energy will be absorbed by volume elements 120 along the propagation path of that beam. Exposure of each volume element by the plurality of illumination beams incident from a large number of directions may cause deposition (by absorption of part of the light) of a certain total amount of energy. This energy may hereafter be referred to as the deposited energy field E defined for volume elements in the medium. Intensity and exposure times, corresponding to the plurality of illumination beams of each wavelength, should be configured such that the deposited energy field E is as close as possible to a target energy field $E_0$ at which the medium in a volume element will polymerize. Each incident illumination beam will propagate through the medium and a non-absorbed part will leave the medium where it may be detected by a detection system, e.g. an imaging system **112.**

A photoinduced chemical process, such as a photopolymerization process or a monomer cross-linking process, can be induced through controlled application of electromagnetic radiation (typically ultra-violet, visible light or, in some cases, infra-red) to a suitable photopolymerizable medium. Photopolymerizable media may include various types of chemical systems which may be based on e.g. free radical polymerization, cationic polymerization, anionic polymerization or acid catalysed polymerization or any other suitable polymerization process. A photopolymerizable medium may contain a photo-initiator component that, when exposed to light of a certain intensity for a certain period, may generate chemical species that participate in the reaction of polymerization. The rate of the reaction will depend, among other parameters, on the concentration of the photo-initiator, its quantum yield, and the amount of illumination energy absorbed by it. In order to improve photo-initiator sensitivity to illumination of a particular wavelength, photosensitizers can be used.

The rotatable illumination system may include one or more light sources **106** for producing one or more source beams that can be pre-shaped by the optical elements **108** and modulated by a computer-controlled spatial light modular (SLM) **110.** Various readily available types of lasers or light-emitting diode sources may be used as a light source. Depending on the photopolymerization process, different sources of different wavelengths may be used. The optical system may include optical elements positioned before and after the spatial light modulator for collimation, beam shaping and focusing. The optical elements may be selected to shape a wide, sufficiently homogeneous beam for exposing the SLM. The SLM comprises individually controllable light valves (pixels) for spatially modulating the intensity of the source beam, producing what is referred to as the illumination beam. It is assumed that laws of geometrical or ray optics are applicable and that the computer-controlled light valves (the pixels) of the SLM may be used to generate a plurality of substantially parallel light rays forming a single illumination beam, while the combination of illumination beams incident from different directions is referred to as illumination field. The intensity of each illumination ray may be controlled by (at least one) of the light valves of the SLM and, depending on implementation, illumination rays that belong to one source beam can be generated simultaneously or in asynchronous manner.

An intensity modulating SLM may be used to modulate the intensity of an illumination beam depending on the direction in which the illumination beam propagates through the space in which the medium is located. The rotatable illumination system can be controlled to expose a predetermined target location of the medium by directing one or more parallel collimating intensity-modulated illumination beams from different source locations towards the target location. This way, a large number of illumination beams which intersect at the target location can be produced. The SLM may be implemented using a liquid-crystal display (LCD), digital light processing (DLP), liquid crystal on silicon (LCoS) or any other optical technology that enables modulation of illumination beams. In an embodiment, if the source used for illumination is coherent, the beam may be generated using a holographic technique instead of an intensity modulation technique. In that case, a phase modulating SLM may be used instead of an intensity modulating SLM.

In an embodiment, the optical system may comprise a detection system **112,** e.g. one or more imaging systems, which may be used to measure the intensity of the light beam that was not absorbed by the medium. The transmitted intensity of the part of the illumination beam that was not absorbed may be used to compute the current absorptivity of the medium during exposure.

The system may include one rotatable illumination system or multiple illumination systems in order to achieve faster energy deposition within the medium. Different illumination systems may comprise light sources of different wavelengths, for instance, to allow Fourier transform infrared (FTIR) measurements.

In order to generate the optimal illumination field and, hence, to deposit the target energy at predetermined locations in the target zone in the medium, the rotatable illumination system may be controlled by a computer system **116.** In particular, the computer system comprises a processor for executing one or more software programs **118** that are configured to control the system. The computer system may include a data storage connected to the processor. The data storage may comprise a 3D data representation **114** of an object of a certain shape that may be reproduced through photopolymerization. The 3D data representation may have a predetermined data format e.g. a voxel representation, point cloud representation or a 3D surface mesh representation of the 3D object **122.**

Additionally, the data structure may define volume elements **119** in the 3D object in which a certain energy field needs to be deposited by one or more direction-dependent illumination beams. The processor may use the 3D data representation of the 3D object to determine a target polymerization zone **124** in the photopolymerizable medium. The target polymerization zone (or, in short, the target zone) may define a volume within the medium that is shaped according to the 3D model. In particular, the target zone may define a volume within the medium that will be exposed by the rotatable illumination system to light of an intensity and a wavelength such that photopolymerization will take place. This way, a photopolymerization process in the target zone can be triggered (activated), maintained and, optionally, inhibited. The result of the photopolymerization process may be solid polymer copy of the object that was provided as a 3D data representation to the computer system.

It is submitted that the system depicted in **Fig. 1** is only a non-limiting example of an exposure system and many variations are possible without departing from the invention. For example, the imaging system may include one or more camera sensors arranged around the reservoir so that the system can image the polymerization process from different angles. Based on these images the system may locally determine relevant parameters, e.g. absorptivity or refractive index of the medium, during exposure and use these measured parameters to update the model that is used to determine the energy that needs to be deposited within the target zone to realize the creation of a 3D object trough photopolymerization.

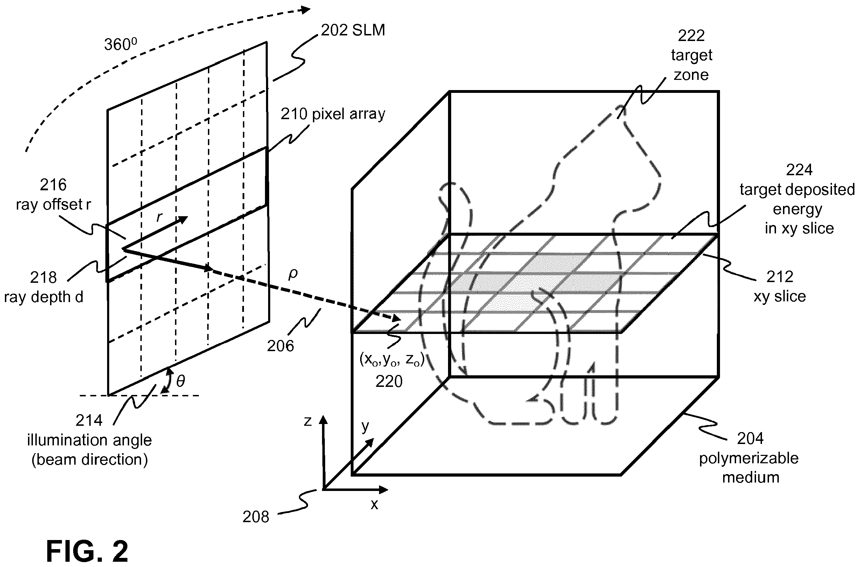

**Fig. 2** depicts a part of the system shown in **Fig. 1** in more detail. In particular, **Fig. 2** illustrates an SLM **202** that is configured to move (rotate) around a transparent container comprising a photopolymerizable medium **204.** As described with reference to **Fig. 1,** the SLM may be used to spatially modulate a source beam through the action of individually addressable light valves, thereby generating intensity modulated illumination beam. Further, various optics can be placed before and after the SLM for focusing and collimation of the illumination beam. Each computer-controlled light valve of the SLM may be used to generate an illumination ray **206** of a predetermined intensity which will contribute to the total deposited energy along its propagation path through the medium. The SLM and the container comprising the medium may be located in a space defined by a coordinate system **208.** The coordinate system may be coordinate system that is suitable for describing the target zone **222** and the propagation of illumination beams through the space, e.g. a Cartesian coordinate system based on three orthogonal axes $\{x,y,z\}$ or any other coordinate system that is suitable for defining positions in a 3D space.

To simplify the mathematical description of the processes executed by the system, it is assumed that the plane of SLM device is positioned in space parallel to the axis $z$ and can rotate around it. It is further assumed that, at least within the boundaries of the photopolymerizable medium, illumination rays propagate in a parallel fashion. In this case, the mathematical description of the transport of the illumination energy is translation invariant along axis $z$. This allows to formulate a model of energy transport and deposition based on illuminated beams modulated by any single horizontal row of SLM pixels **210** in any x-y plane **212** independently from the others and omit z axis in the derivations. In practice, a set of illumination beams propagating in a parallel fashion can only be generated for rays significantly wider than the diffraction limit of the optical system. It is assumed that either the target resolution is low enough so that it is not limited by diffraction or that a parallel beam can be emulated through the use of Bessel lenses or rapid adaptive lenses such as TAG lenses or similar devices.

If the illumination beams generated by the SLM propagate in a parallel fashion, every illumination beam generated by a pixel of the SLM may be defined by:

- an illumination angle $\theta$, **214** defining an angle between the direction of the illumination beam and the x-axis,
- an offset r, **216** defining the position of the pixel within the horizontal row **210,**

- a height *z*, and,
- a beam length (or depth) $\rho$ **218** defining a distance between the origin of the ray and a location {$x_0$,$y_0$,$z_0$} inside the medium **220**.

Controlling each row of pixels while rotating the SLM around the photopolymerizable medium allows to generate the illumination field $I_0$ (*r*, $\theta$, *z*) pre-computed according to the predetermined target energy $E_0$(*x*, *y*, *z*) **224.**

While a more detailed model of monomer to polymer conversion can be considered, in an embodiment, a model may be used which assumes that to sustain a photopolymerization process in the target zone, the energy *E*(*x*, *y*, *z*) absorbed by the photo-initiator at positions in the target zone needs to exceed a certain critical threshold $E_{crit}$. In another embodiment, when radiation comprising a plurality (several) wavelengths is used to concurrently control initiation and, optionally, inhibition of the photopolymerization reaction, a conversion model can be introduced where a certain linear combination of the corresponding deposited energies associated with the different wavelengths should exceed a critical value $E_{crit}$. Using the intensity-modulated illumination beams, the polymerization process may be locally controlled in a plurality of positions in the target zone, a 3D object can be formed in the medium.

The formation of a certain 3D object however may require a complex direction-dependent illumination process of the medium by the illumination system wherein parameters that contribute to the attenuation of the light during exposure may be considered. In an embodiment, a computational approach based on an analytical model describing a weakly attenuating medium may be used to determine an exposure time *t* and illumination intensity $I_0$(*r*,$\theta$,*z*) to sustain and control the polymerization reaction within an accurately defined target polymerization zone. A single or multiple exposures of the target polymerization zone may generate a solid polymer object as defined by the 3D data representation of the object that was provided to the input of the computer. Hereunder, methods and systems are described to control the system initiation and inhibition of the polymerization reaction in a target zone of a photopolymerizable medium. These embodiments are described hereunder in more detail.

The fraction of the incoming electromagnetic energy that is absorbed by a volume element of any component of the photopolymerizable medium upon illumination may be described by an absorptivity function $\mu$. Absorptivity is related to commonly used quantities, namely a molar extinction $\varepsilon$ and a concentration of the photoreactive component $C_p$, as: $\mu = \varepsilon \cdot C_p$. Instead of the standard definition of absorptivity coefficient (as commonly used in chemistry), a modified absorptivity may be used that allows to shorten mathematical notation in the mathematical description of the various embodiments in this application. The modified absorptivity may be defined as $\mu = \varepsilon \cdot C_p \cdot ln(10)$, where $ln(10) \approx 2.303$.

This function depends on the wavelength of the electromagnetic radiation and can be determined empirically or computed. When a homogeneous photopolymerizable medium is illuminated by radiation of a wavelength $\lambda$, the radiation intensity *I* at depth $\rho$ is described by Beer-Lambert's law:

$$I(\lambda, \rho) = I(\lambda, 0) \cdot \exp(-\mu_{tot}(\lambda) \cdot \rho) \qquad (1)$$

wherein *I* ($\lambda$, 0) is the intensity upon incidence, $\mu_{tot}(\lambda)$ is the combined absorptivity of all components of the photopolymerizable medium (photo-initiators, photosensitizers, photoinhibitors, dyes, other attenuating additives).

By taking a derivative of the illumination intensity: $I(\lambda,\rho)$ and multiplying it by the exposure time *t,* the energy $E_{tot}(\lambda,\rho)$ absorbed by an element of volume at depth $\rho$ can be calculated:

$$E_{tot}(\lambda, \rho) = -\frac{\partial}{\partial \rho} I(\lambda, \rho) \cdot t \qquad (2)$$

$$E_{tot}(\lambda, \rho) = \mu_{tot}(\lambda) \cdot t \cdot I(\lambda, 0) \cdot \exp(-\mu_{tot}(\lambda) \cdot \rho) \qquad (3)$$

Typically, only a fraction of that energy will be absorbed by the photo-initiator or/and the photosensitizer, so the amount of "useful" energy $E_+$ ($\lambda$, $\rho$) initiating the polymerization reaction may be determined by the following expression:

$$E_+(\lambda, \rho) = \mu_+(\lambda) \cdot t \cdot I(\lambda, 0) \cdot \exp(-\mu_{tot}(\lambda) \cdot \rho) \qquad (4)$$

where $\mu_+(\lambda)$ is the absorptivity of the photo-initiator or the photosensitizer. The degree of polymerization that leads to formation of a solid material is typically associated with a certain critical energy $E_{crit}$, such that:

$$E_+(\lambda, \rho) > E_{crit} \tag{5}$$

where, $E_{crit}$, may be determined empirically or calculated using a reaction kinetics model.

When multiple illumination beams intersecting at a certain depth are used to initiate the reaction of polymerization, the combined intensity at the intersection point should be at least greater than the intensity at zero depth. Considering the Beer-Lambert's law, a simple condition for the minimum number of illumination beams $N_\theta$ that are needed to illuminate a single point at the centre of the volume at depth $\rho$ can be calculated:

$$N_\theta > \exp(\mu_{tot}(\lambda) \cdot \rho) \tag{6}$$

This condition provides a rough notion of the number of illumination beams needed to create a sufficient contrast to polymerize the deepest point in the volume of a certain size before the less deep parts of the volume are polymerized. For instance, for absorptivity $\mu_{tot}$ = 1 $cm^{-1}$ (absorptivity considered in One-step volumetric additive manufacturing of complex polymer structures, Science Advances 8 Dec 2017, vol. 3) at least three illumination beams are needed to create enough contrast at a depth of 1 cm. However, to increase the illumination depth to 5 cm more than 300 intersecting illumination beams are required. Polymerizable media with lower absorptivity will be suitable for illumination at higher depths.

Even when condition expressed by Eq. 6 is satisfied, the illumination energy will be absorbed by the photo-initiator on its path to the target zone, thereby dramatically limiting the resolution with which the boundary of the target zone can be defined. In order to overcome the problem of limited boundary contrast, the polymerization reaction may be terminated (inhibited) in some of the previously illuminated areas. In that case, a mechanism for polymerization inhibition or polymerization deactivation can be employed. Examples of such mechanisms are known from Resolution Augmentation through Photoinduced Deactivation (RAPID) lithography, PhotoInhibited Super Resolution (PInSR) lithography and multi-colour photolithography. In these approaches, a single source or multiple sources operating at different wavelengths are used to initiate the photopolymerization reaction and subsequently deactivate or substantially inhibit it.

For instance, in PInSR a photo-initiator camphorquinone sensitive to blue light is used in combination with photo-inhibitor tetraethylthiuram disulfide sensitive to ultra-violet light. In this approach, photoinitiation and photoinhibition reactions are controlled by two light sources: a blue diode-pumped solid-state laser with 473 nm wavelength and ultra-violet argon ion laser with a 365 nm wavelength. The 473 nm wavelength light is absorbed by the photo-initiator which leads to production of free radicals involved in polymerization reaction, while 365 nm light is absorbed by the photo-inhibitor and generates radical traps that terminate polymerization.

Depending on the type of the photopolymerizable medium and the type of inhibition or deactivation approach, accurate description of the kinetics of the polymerization reaction may require more complex models: typically, rate equations based on partial differential equations). Typically, rate equations based on partial differential equations, random graph or reactive force field approaches. In that case, in an embodiment, the polymerization reaction model may be regarded as an optimization problem where a conversion described by a model $\mathcal{P}[\mathrm{E}_+, \mathrm{E}_-]$ has to exceed a critical conversion $\mathcal{P}_{\mathrm{crit}}$ inside the target zone and stay below $\mathcal{P}_{\mathrm{crit}}$ outside of the target zone, i.e.: $\mathcal{P}[\mathrm{E}_+, \mathrm{E}_-] > \mathcal{P}_{\mathrm{crit}}$.

In an embodiment, a semi-empirical model for describing the activation and inhibition of the polymerization process may be used. In such scheme, polymerization may be achieved when a certain linear combination of the energy $E_+$ associated with initiation and the energy $E_-$ associated with inhibition (or deactivation) of the polymerization exceeds a critical value:

$$E_+(\lambda_+, \rho) - \beta \cdot E_-(\lambda_-, \rho) > E_{crit}, \tag{7}$$

wherein the parameter $\beta$ is a proportionality constant and the wavelengths $\lambda_+$ and $\lambda_-$ are respectively wavelengths at which the photo-initiator and the photo-inhibitor absorb photons respectively. Constant $\beta$ may be computed using rate equations or measured for a particular photopolymerizable medium. A resulting combined deposited energy $E(\lambda, \rho)$ may define a linear combination of deposited energies $E_+(\lambda_+, \rho) - \beta \cdot E_-(\lambda_-, \rho)$ for systems with "active" inhibition. In case of "passive" inhibition, the deposited energy can be described by the single term $E_+(\lambda_+, \rho)$ minus a constant.

In an embodiment, one or more time dependent terms or non-linear terms of the form $E_+(\lambda_+, \rho) \cdot E_-(\lambda_-, \rho)$ may be used to yield a better approximation of the model $\mathcal{P}[\mathrm{E}_+, \mathrm{E}_-]$. For instance, time dependent terms may be used to represent effects of depletion of the initiator or inhibitor molecules during the illumination if such effects become apparent in a particular regime. An expression for the deposited energy with a larger number of terms can be considered for systems with a larger number of photosensitive components.

In an embodiment, a computational approach may be used to compute the illumination intensity for each direction of illumination that is required to facilitate deposition of the correct quantities of initiation energy $E_+$ and inhibition energy $E_-$ in every location of the polymerization volume. The underlying mathematical model of the deposited energy $E(x, y, z)$ may be defined as follows:

$$E(x, y, z) = t \cdot \mathcal{M}[I_0(r, \theta, z)], \qquad (8)$$

wherein $\mathcal{M}$ is an operator that describes the deposition of energy in the volume of photopolymerizable medium given a direction-dependent illumination field $I_0(r, \theta, z)$. An optimal illumination field $I_0(r, \theta, z)$ may be computed by searching for a solution for Eq. 8 after substituting the target energy field $E_0(x, y, z)$ in the right-hand side of the equation. If an inverse operator

$$\mathcal{M}^{-1}$$

can be calculated, an analytical solution may be used:

$$I_0(r, \theta, z) = \frac{1}{t} \cdot \mathcal{M}^{-1}[E_0(x, y, z)] \qquad (9)$$

In a further embodiment, an iterative solver algorithm may be used to find an approximated solution to Eq. 8. For instance, a well-known Least-Squares minimization algorithm may be employed to find $I_0(r, \theta, z)$ corresponding to a minimum of an objective function:

$$\underset{I_0}{argmin} \, |t \cdot \mathcal{M}[I_0(r, \theta, z)] - E_0(x, y, z)|_2^2 \qquad (10a)$$

Wherein the notation $|\cdot|_2^2$ denotes the Euclidean norm (or L2 norm). A regularization term of some sort can be added to the L2 term to constrain possible solutions for $I_0(r, \theta, z)$ to physically more appropriate ones.

In a further embodiment, the polymerization model may be a non-linear polymerization model $\mathcal{P}[E_+, E_-]$. In that case, an iterative solver algorithm may be used to find $I_+(r, \theta, z)$ and $I_-(r, \theta, z)$ corresponding to a more 'high-level' objective function:

$$\underset{I_+, I_-}{argmin} \, |\mathcal{P}[E_+, E_-] - \mathcal{P}_0(x, y, z)|_2^2 \qquad (10b)$$

Here, $E_+$ and $E_-$ may be computed using the light propagation and absorption model (8). While the optimization problem above is designed to solve equations of the type $\mathcal{P}[E] = \mathcal{P}_0$, different approaches may be used to solve inequalities of the type $\mathcal{P}[E] \geq P_0$ to allow for over-exposure of already solidified parts of build volume. For instance, model $\mathcal{P}[E]$ can be expressed via a sigmoid function, allowing for over-exposure.

Operator $\mathcal{M}$ may be based on a model of photon propagation and absorption inside the photopolymerizable medium and its particular form may depend on one or more parameters, including e.g. parameters of the illumination system, type of the medium and the level of acceptable approximations. This operator may hereafter be referred to as the propagation operator $\mathcal{M}$.

Below a more detailed embodiment of an implementation of the propagation operator $\mathcal{M}$ based on the Radon transform is provided. In this embodiment, it is assumed that photons propagate along straight paths in a parallel fashion. More accurate models such as a model based on the so-called Radiative Transport Equations or a Monte Carlo approach may be used when effects such as refraction, diffraction and/or scattering are considered.

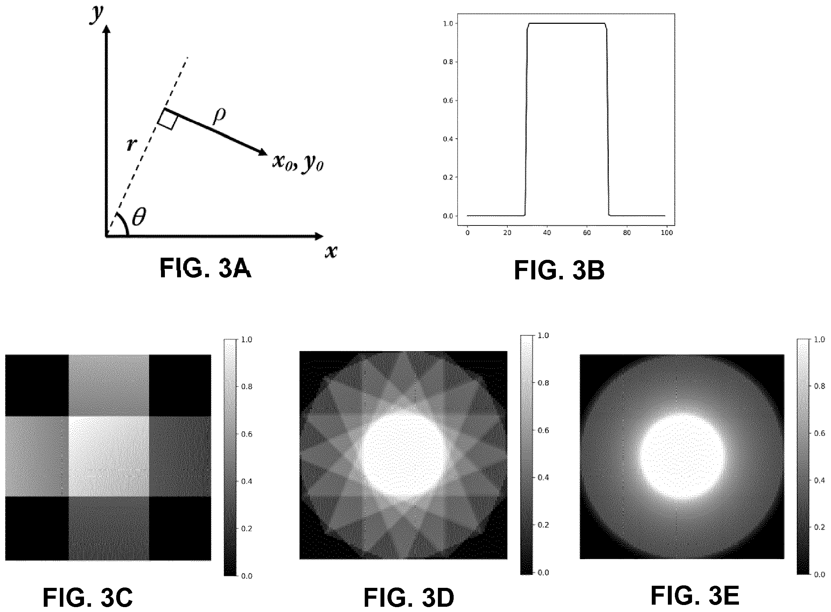

**Fig. 3A-3E** depict a simulated energy deposition resulting from a superposition of multiple illumination beams, wherein beams of uniform intensity are used. In this example, the target shape is a solid cylinder in a photopolymerizable medium with absorptivity of 1 cm$^{-1}$ inside a container of dimensions 1 x1 cm (in x-y plane). **Fig. 3A** depicts the relation between the {x,y} coordinates and the {r,ρ,θ} coordinates (as described in detail with reference to **Fig. 2**. **Fig. 3B** depicts a normalized intensity profile of a 0.4 cm wide illumination beam of uniform intensity. **Fig. 3C** depicts a simulated energy field deposited in a photopolymerizable medium when two orthogonal illumination beams of uniform intensity are used. By extending the illumination process to a higher beam number, it is possible to generate a deposited energy field that is closer to a circular target energy field. **Fig. 3D** and **3E** depict examples of the deposited energy field resulting from 16 and 314 illumination beams respectively. In **Fig. 3E** a circular distribution of the energy is achieved wherein each point of the medium that absorbs energy larger than a critical energy $E_{crit}$ will be polymerized. However, as shown in these figures, the polymerization zone does not exhibit a sharp boundary in this example since energy of every incoming illumination beam is absorbed along the whole propagation path. This will lead to a substantial loss of resolution due to fluctuations in the properties of the photopolymerizable medium and errors in the illumination.

As described with reference to **Fig. 3A,** any position (defined by the coordinates {x,y}) on a 2D plane can be illuminated by a plurality of illumination rays characterized by illumination angle $\theta$, offset r and depth $\rho$. This two-dimensional description is sufficient for the case of parallel beam illumination with rotation around axis *z* (due to translational invariance along the rotation axis). In more complex cases, the scheme may be easily generalized to three-dimensions based on a suitable coordinate system.

The intensity of the illumination may be described by a direction depended illumination field $I_0(r, \theta)$. A location {x,y} can be illuminated only by sources located on straight lines intersecting with that location, so that the offset $r_0$ of these illumination sources may be described by the following expression:

$$r_0(\theta) = x \cdot \cos(\theta) + y \cdot \sin(\theta) \qquad (11)$$

and the total intensity that is directed to a location {x,y} can be described by an integral:

$$I(x,y) = \int_0^{2\pi} \int_{-\infty}^{\infty} I_0(r,\theta) \cdot \delta(x \cdot \cos(\theta) + y \cdot \sin(\theta) - r) dr d\theta \qquad (12)$$

Here $\delta(\cdot)$ represents a Dirac function. To account for attenuation of light along its propagation path, an integral absorptivity factor is introduced in accordance with Beer-Lambert's law. To do that, an absorptivity has to be defined on the x-y grid parametrized by the depth $\rho$ and offset $r_0(\theta)$:

$$x = r_0(\theta) \cdot \cos(\theta) + \rho \cdot \sin(\theta)$$
$$y = r_0(\theta) \cdot \sin(\theta) - \rho \cdot \cos(\theta) \qquad (13)$$

Combining Eq. 11 and Eq. 13, one finds an expression for Beer-Lambert's law of attenuation based on the total absorptivity of the polymerization medium $\mu_{tot}(x, y)$ for the direction $\theta$. This attenuation term $T(x,y,\theta)$ looks as follows:

$$T(x,y,\theta) = \exp(- \int_{-\infty}^{\rho_0} \mu_{tot} (\rho \cdot \sin(\theta) + (x \cdot \cos(\theta) + y \cdot \sin(\theta)) \cdot \cos(\theta),$$

$$-\rho \cdot \cos(\theta) + (x \cdot \cos(\theta) + y \cdot \sin(\theta)) \cdot \sin(\theta)) d\rho \qquad (14)$$

where depth $\rho = -\infty$ corresponds to the outwards direction and depth $\rho = \rho_0$ corresponds to the location {x,y} inside the medium. Value of $\rho_0$ can be expressed through *x,y* and $\theta$ as:

$$\rho_0 = x \cdot cos(\theta) - y \cdot \sin(\theta) \qquad (15)$$

The attenuated total illumination intensity $\hat{I}$ at location $\{x,y\}$ can be derived by combining the expression for the total illumination intensity from Eq. 12 with the attenuation term from Eq. 14:

$$\hat{I}(x,y) = \int_0^{2\pi} \int_{-\infty}^{\infty} I_0(r,\theta) \cdot \delta(x \cdot \cos(\theta) + y \cdot \sin(\theta) - r)dr \cdot T(x,y,\theta)d\theta$$

$$(16)$$

Finally, assuming that the absorptivity is constant within the boundaries of the photopolymerizable medium, the energy $E(x,y)$ associated with photo-initiation at any point $\{x,y\}$ can be computed similarly to Eq. 4:

$$E(x,y) = \mu_+ \cdot t \cdot \int_0^{2\pi} \int_{-\infty}^{\infty} I_0(r,\theta) \cdot \delta(x \cdot \cos(\theta) + y \cdot \sin(\theta) - r)dr \cdot T(x,y,\theta)d\theta$$

$$(17)$$

Now, the direction-dependent illumination intensity $I_0(r, \theta)$ can be computed by solving Eq. 17 after substitution of the target energy $E_0(x,y)$ into the right-hand side. In a system with active photo-initiation and photo-inhibition, two terms should be considered, such that $E(x, y) = E_+(x,y) - \beta \cdot E_-(x,y)$ and:

$E(x, y) > E_{crit}$ for $\{x, y\}$ inside the target polymerization zone,

$E(x, y) < E_{crit}$ for $\{x, y\}$ outside of the target polymerization zone (18)

To find an analytical solution for Eq. 18 a weakly attenuating medium may be assumed, neglecting the attenuation term $T(x,y,\theta)$ in the Eq. 17. In that case, the expression for the deposited illumination energy $E(x, y)$ may be simplified:

$$E(x,y) = \mu_+ \cdot t \cdot \int_0^{2\pi} \int_{-\infty}^{\infty} I_0(r,\theta) \cdot \delta(x \cdot \cos(\theta) + y \cdot \sin(\theta) - r)drd\theta \qquad (19)$$

In fact, the integral in Eq. 19 is a form of the so-called adjoint Radon transform and allows to compute an optimal illumination intensity analytically. A definition for the Radon transform and its adjoint form is provided hereunder. The Radon transform is a linear transformation that defines a series of line integrals applied to a function $f(x,y)$ defined on a 2D plane. It can be written in the following form:

$$p(r,\theta) = \int_{-\infty}^{\infty} \int_{-\infty}^{\infty} f(x,y) \cdot \delta(x \cdot \cos(\theta) + y \cdot \sin(\theta) - r)dxdy \qquad (20)$$

this transformation may be referred to as the forward Radon transform. Here, the direction-dependent function p(r, $\theta$) may be regarded as a collection of projections of an image defined by $f(x,y)$, which is often used in Computed Tomography applications. The adjoint Radon transform can be defined by the following integral:

$$f(x,y) = \int_{-\infty}^{\infty} \int_0^{2\pi} \hat{p}(r,\theta) \cdot \delta(x \cdot \cos(\theta) + y \cdot \sin(\theta) - r)d\theta dr \qquad (21)$$

wherein the function $\hat{p}(r, \theta)$, to which the adjoint Radon transform is applied, can be related to the result of the forward Radon transform $p(r, \theta)$ (Eq. 20) through convolution or Fourier filtering (a so-called ramp filter or similar):

$$\hat{p}(r,\theta) = \int_{-\infty}^{\infty} |\omega| \left( \int_{-\infty}^{\infty} p(\bar{r},\theta) \cdot \exp(-j2\pi\bar{r}\omega)d\bar{r} \right) \cdot exp(j2\pi r\omega)d\omega \qquad (22)$$

Integrals in Eq. 20-22 can be written in the form of linear operators leading to the following expressions:

$$p(r,\theta) = \mathcal{R}f(x,y),$$
$$f(x,y) = \mathcal{R}^*\hat{p}(r,\theta), \tag{23}$$
$$\hat{p}(r,\theta) = \mathcal{F}p(r,\theta),$$

wherein $\mathcal{R}$ and $\mathcal{R}^*$ are the Radon transform and its adjoint version respectively, and $\mathcal{F}$ is the Fourier filtering operator. Using this notation, a function $f(x, y)$ can be expressed through the adjoint Radon transform of its own filtered projection:

$$f(x,y) = \mathcal{R}^*\mathcal{F}\mathcal{R}f(x,y) \tag{24}$$

Hence, according to Eq.19, in an embodiment, the deposited energy can be modelled as an adjoint Radon transform of the direction-dependent illumination intensity $I_0$ $(r, \theta)$:

$$E(x,y) = \mu_+ \cdot t \cdot \mathcal{R}^* I_0(r,\theta) \tag{25}$$

Comparing Eq. 25 with Eq. 24, it can be seen that the illumination intensity $I_0(r,\theta)$ that corresponds to a certain deposited energy $E(x, y)$, can be computed using a filtered Radon transform:

$$I_0(r,\theta) = \frac{1}{\mu_+ \cdot t}\mathcal{F}\mathcal{R}[E(x,y)] \tag{26}$$

Hence, this equation is a special case of Eq. 9 and may be used to calculate the direction-dependent intensity of illumination analytically in case of a weakly attenuating polymerization medium.

The optimal direction-dependent illumination intensity $I_0(r, \theta)$ according to Eq. 26 may be solved for a finite number of illumination angles and associated illumination beams, thus integrals in linear operators are replaced by finite sums. To avoid sampling artefacts, the number of offsets (i.e. illumination rays) $N_r$ in each illumination beam may correspond to the desired spatial resolution of $E(x,y)$. Further, to avoid aliasing artefacts, the number of illumination angles (i.e. illumination beams) $N_\theta$ may be related to the number of offsets $N_r$ by using the expression: $N_\theta \geq \pi N_r$. For instance, when an image of 1024 x 1024 pixels needs to be formed by multi-directional illumination of a target zone, approximately 3200 illumination beams with 1024 rays each may be generated in 0 to $2\pi$ angular range.

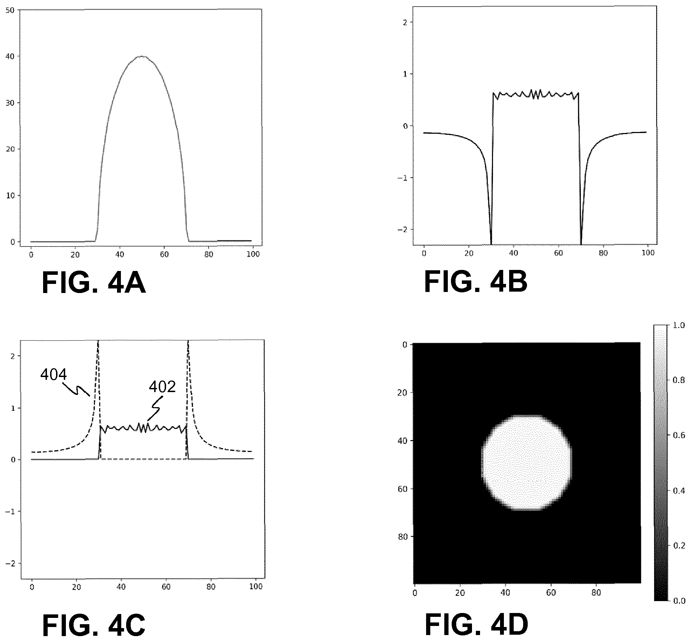

**Fig. 4A-4D** depict a simulated energy deposition resulting from a superposition of multiple illumination beams, wherein beams were precomputed and generated according to an analytical model valid for media with weak absorptivity. The multiple illumination beams were pre-computed using an analytical model described above. **Fig. 4A** depicts a Radon transform (projected image) of a target energy $\mathcal{R}[E(x,y)]$ . It is the same in every direction, as the target polymerization zone is circular in this example. **Fig. 4B** depicts an illumination field $I_0(r, \theta)$ computed by applying a Fourier filter (e.g. ramp filter) to the Radon transform of the target energy field as defined by Eq. 26. It is apparent that the computed illumination intensity has negative values which do not have any physical meaning in a read-world system. The negative values however can be associated with the intensity of the light interacting with the inhibition/deactivation agent. In an embodiment, in case of passive (ambient) inhibition, a constant offset can be added to the illumination intensity that matches the effect of the inhibitor. This way the illumination intensity will always be above zero. Alternatively, in another embodiment, in case of active inhibition, $I_0(r, \theta)$ can be separated into two terms related to the initiation and inhibition: $I_0$ $(r, \theta) = I_+$ $(r, \theta) - \beta \cdot I_-(r, \theta)$. In that case, the terms can be defined as:

$$I_+(r,\theta) = \begin{cases} |I_0(r,\theta)|, & if\ I_0(r,\theta) > 0 \\ 0, & otherwise \end{cases}$$
$$I_-(r,\theta) = \begin{cases} -|I_0(r,\theta)|/\beta, & if\ I_0(r,\theta) < 0 \\ 0, & otherwise \end{cases} \tag{27}$$

**Fig. 4C** depicts the intensity of the photo-initiation illumination field $I_+(r, \theta)$ (**402** continuous line) and the intensity of the photo-inhibition illumination field $I_-(r,\theta)$ (**404** dotted line). The associated (combined) deposited energy field $E(x,y)$ resulting from illumination by 314 beams is depicted in **Fig. 4D**. The wavelength of the initiation illumination differs from the wavelength of the inhibition illumination. As the linear absorptivity may be wavelength dependent, absorptivity associated with the initiation illumination may be different from the absorptivity associated with the inhibition illumination. In contrast to the example with the uniform intensity beam illumination (**Fig. 3E**), an approach described above leads to a sharply defined polymerization zone allowing for high resolution of the printed object boundary.

The computation described above is based on the assumption of weak absorption, where the direction-dependent absorption term is neglected. Reviewing Eq. 17, where the energy is expressed including the absorption term $T(x,y,\theta)$, a Radon-based computation method can be derived that incorporates self-absorption by the medium. To simplify the description, it may be assumed that the total absorptivity at the wavelength that corresponds to $I_+(r, \theta)$ term and to $I_-(r, \theta)$ is the same: $\mu_+ = \mu_- = \mu$. To this end, Eq. 17 can be rewritten for the photo-initiation and photo-inhibition energy terms using a short operator notation:

$$E_+(x,y) = \overline{\mu \cdot t} \cdot \widetilde{\mathcal{R}}^* I_+(r,\theta)$$
$$E_-(x,y) = \mu \cdot t \cdot \widetilde{\mathcal{R}}^* I_-(r,\theta) \tag{28}$$

where $\widetilde{\mathcal{R}}^*$ is a modified adjoint Radon transform incorporating an attenuation term $T(x,y,\theta)$. Now, Eq. 28 can be condensed into the following form:

$$E(x,y) = \mu \cdot t \cdot \widetilde{\mathcal{R}}^* I_0(r,\theta) \tag{29}$$

Combining this result with the polymerization condition expressed in Eq. 18, the optimal illumination intensity functions $I_+(r, \theta)$ and $I_-(r, \theta)$ can be computed for a given target energy $E_0(x, y)$ using a Least-Squares approach described by Eq. 10 where the propagation operator $\mathcal{M}$ equals to $\mu \cdot \widetilde{\mathcal{R}}^*$:

$$\underset{I_0(r,\theta)}{argmin} \left| \mu \cdot t \cdot \widetilde{\mathcal{R}}^* I_0(r,\theta) - E_0(x,y) \right|_2^2 \tag{30}$$

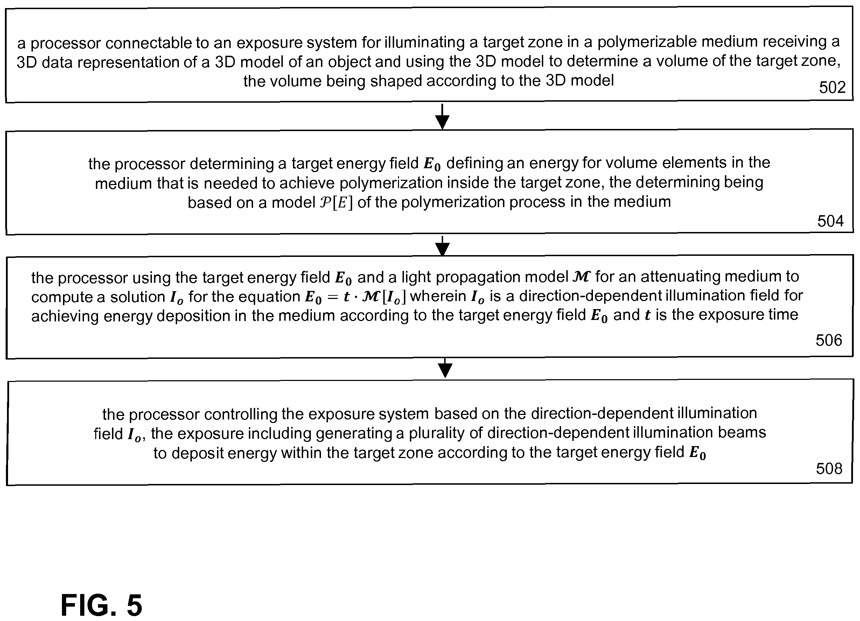

**Fig. 5** depicts a flow diagram describing a method of controlling an illumination system for illuminating a target zone in a photopolymerizable medium according to a part of an embodiment of the invention. The method may include determining direction-dependent illumination field based on target energy field determined for a target polymerization zone based and a low absorptivity light propagation model. The method may be implemented on a computer in the form of program code stored in the memory of the computer. The program code may be executed by a processor of the computer thereby enabling the computer to determine direction-dependent illumination intensities which can be used to control an exposure system, e.g. a system as described with reference to **Fig. 1**. The computed illumination intensity may be used to control and generate a plurality of direction-dependent exposures leading to the desired photopolymerization of the target zone.

In a first step, a 3D data representation representing a 3D model of an object may be provided to a computer that is connected to an exposure system for illumination of the target zone, e.g. an exposure system described with reference to **Fig. 1** and **2**. The computer may use the 3D model to determine a volume of a target polymerization zone in the photopolymerizable medium **502**. The volume may be shaped according to the 3D model. In a next step **504**, the computer may determine a target energy field $E_0$ defining an energy for volume elements in the medium that is needed to achieve polymerization inside the target zone. Here, the computer may determine a target energy field $E_0$ based on a model $\mathcal{P}[E]$ of the polymerization process in the medium. The target energy field may define the energy that is needed to achieve polymerization inside the target polymerization zone or in short, the target zone. The determination of the target energy field may be based on a model P[E] of the photopolymerization process.

Here the polymerization model may be based on an empirical model of the photopolymerization process or a model based on the polymerization kinetics. In an embodiment, target energy $E_0$ may be a function of $E_+$ and $E_-$ and polymerization is achieved in case $E_0$ exceeds a certain critical value $E_{crit}$. For example, a linear polymerization model of the type $E_0 = E_+ - \beta \cdot E_-$ may be used to determine the target energy wherein polymerization is achieved when a weighted difference between the energy absorbed by the photo-initiator $E_+$ and the energy absorbed by the inhibitor (or involved in deactivation of polymerization on another way) $E_-$ exceeds $E_{crit}$.

The computer may then use the target energy field $E_0(x, y, z)$ and a light propagation model $\mathcal{M}$ for a attenuating medium to compute a direction-dependent illumination field $I_0(r, \theta, z)$ (step **506**). In a weakly attenuating medium a projection of the target energy field $E_0(x, y, z)$ can be computed for every direction of illumination. A projection $p(r, \theta, z)$ of the target energy $E_0(x, y, z)$ can be computed by applying a forward projection operator based on the Radon transform $\mathcal{R}$ (or similar transforms computing projections of a 3D image) to the target energy field. Subsequently a linear convolutional filter $\mathcal{F}$ (e.g. ramp or Ram-Lak filter) may be applied to the projection of the energy thereby defining a direction-dependent illumination field $I_0(r, \theta, z)$. Hence, the illumination field may be determined on the basis of a filtered Radon transform of the target energy field as defined by eq. (26) above.

In a next step **508,** the computed illumination field $I_0(r, \theta, z)$ may be used by the computer to control the exposure system based on the illumination field, wherein the exposure may include generating a plurality of direction-dependent illumination beams for depositing energy at positions within the target zone according to the target energy $E_0(x, y, z)$. Here, it is assumed that the power of the illumination source and the exposure time are kept constant, while the intensity $I_0(r, \theta, z)$ is controllably varied, e.g. by controlling the pixels of the SLM and the illumination angle. The illumination angles and associated illumination intensities may be used to control the rotation of the rotatable illumination system and to control the SLM in the rotatable illumination system depicted in **Fig. 1.** It is submitted that the target energy field and the intensity field as mentioned above may be described based on coordinate systems that are suitable for a particular case. Selection of such coordinate systems, as well as the type of the Fourier filter and the projection transformation may depend on the symmetry of the setup (e.g. cylindrical or spherical symmetry)

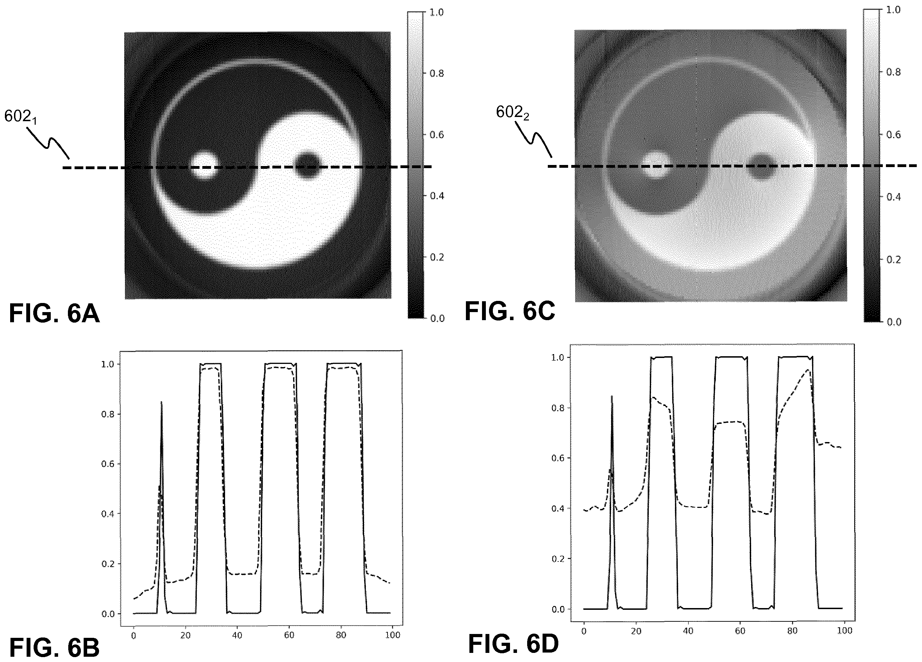

**Fig. 6A-6D** depict examples of computed energy deposition for a 3D object (x-y slice displayed) based on the weak absorptivity model .

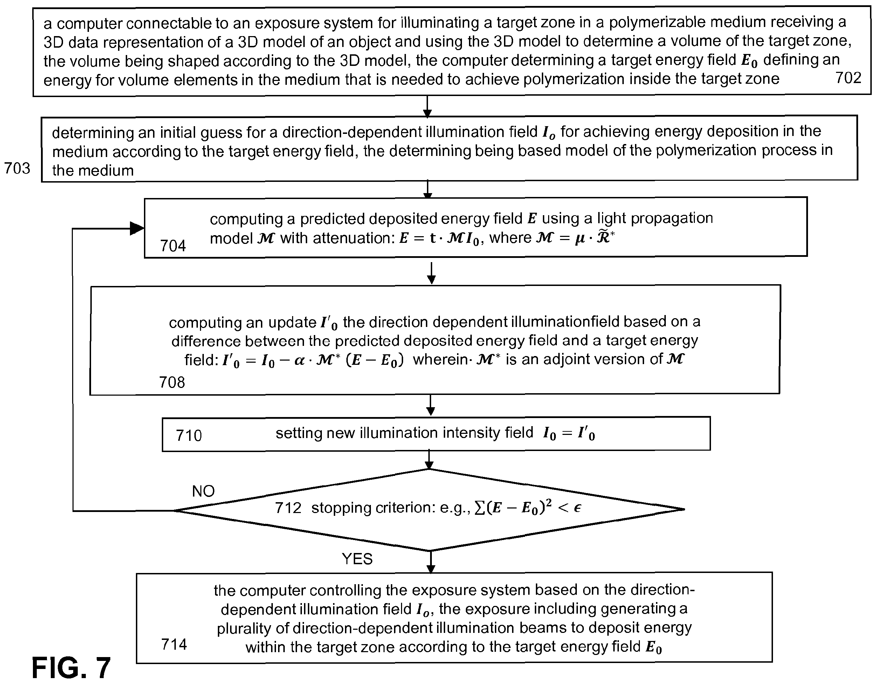

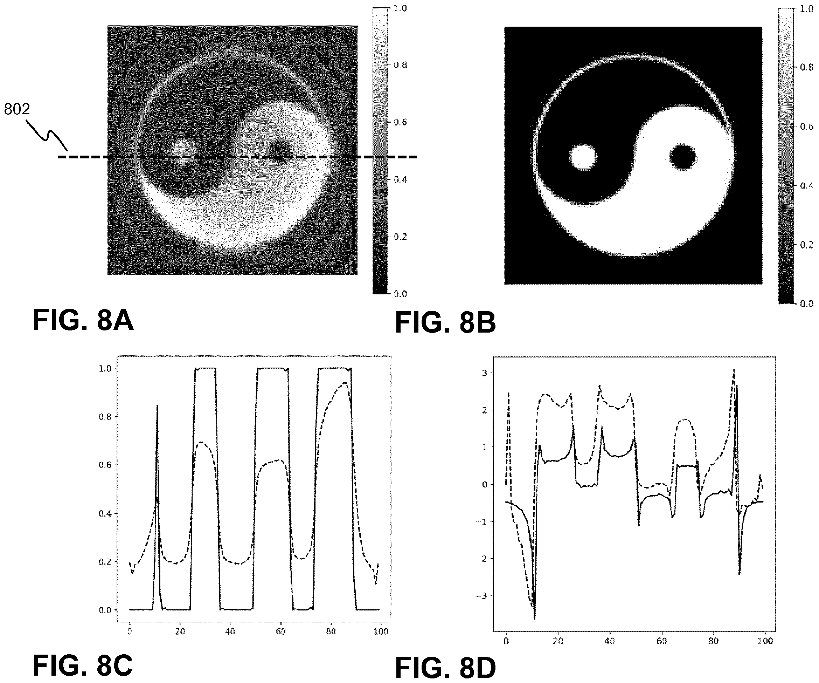

In particular, **Fig. 6A-6D** depict examples of computed energy deposition for a fairly complex object, in this case a $1 \times 1$ cm image of a Yin-Yang shaped object. **Fig. 6A-B** and **Fig. 6C-D** depict computed energy deposition for the 3D object in a moderate absorptivity medium ($\mu$ = 1 cm$^{-1}$) and a high absorptivity medium ($\mu$ = 5 cm$^{-1}$) medium respectively. **Fig. 6B** and **6D** represent cross-sections through the mid-line **602$_{1,2}$** of **Fig. 6A** and **6C** respectively, wherein the solid line represents the profile of the target energy and wherein the dashed line represents the actual deposited energy. The images depicted in these figures are formed by 314 beams of 100 rays each. **Fig. 6A** and **6B** show that in a moderately attenuating medium, an accurate image of the object can be formed by multidirectional illumination with intensity calculated using weak absorptivity model. **Fig. 6C** and **6D** show that when the absorbance of the medium is high (or the size of the volume is too large), such approach may provide poor contrast. In that case, an iterative approach may be used to determine the illumination intensity. This approach is described hereunder in more detail with reference to **Fig. 7** and **Fig. 8.**

The photopolymerizable medium and the illumination wavelength may be selected to minimize these effects. Eventually, a more precise model relating the illumination field to the deposited energy field (for the photo-initiator and the inhibitor) can be used for a particular implementation of the illumination system.

A further assumption that was made in order to derive Eq. 29 is that the absorptivity is constant in time and does not change as a result of illumination. Concentrations of the photo-initiator and the inhibitor however may locally change during the illumination of the medium by the illumination beams leading to the change in absorptivity. Similarly, as a result of polymerization dynamics, the proportionality constant $\beta$ in the polymerization condition as expressed by Eq. 7 may vary during the illumination.

To account for unknown changes in the parameters of the photopolymerizable medium, the computation of energy deposition and the associated illumination may be separated into a number of iterations, where during each iteration the medium is exposed to a relatively low illumination energy wherein parameters of the medium can be considered constant. One way to monitor parameters of the medium is to measure the intensity of light transmitted through the medium during the illumination process. If such measurement is available, the linear absorptivity of the medium can be computed using known Computed Tomography methods as for example described by Herman, G. T., Fundamentals of computerized tomography: Image re-construction from projection, 2nd edition, Springer, 2009, using e.g. a filtered back projection method:

$$\mu(x, y) = \mathcal{R}^* \mathcal{F} \left[ -\log\left(\frac{I_{out}(r, \theta)}{I_0(r, \theta)}\right) \right] \tag{31}$$

wherein, $I_{out}(r, \theta)$ is the intensity of the light transmitted through the medium.

Propagation-based Phase-Contrast Tomography can be used similarly to the conventional tomography, in order to detect local changes in the refractive index of the medium due to polymerization in real-time. This method could allow to monitor the degree of polymerization indirectly even when changes in absorptivity of the medium are too small to detect. The calculated refractive index can be incorporated in the light propagation model in addition to the linear absorptivity. This will, however, require a different model rather than a Radon-based one.

A direct real-time measurement of the degree of polymerization can be obtained using more elaborate spectral measurements of transmitted light using Fourier-transform infrared spectroscopy (FTIR) tomography methods as described in 3D spectral imaging with synchrotron Fourier transform infrared spectro-microtomography Nature Methods volume 10, pages 861864 (2013).

The embodiments described in this application may not only be used for creating a 3D object in the photopolymerizable medium from scratch. A 3D object may be printed around or on an existing 3D object. Such object can be introduced into the reservoir prior to the printing process. The presence of the 3D object will alter the total absorptivity of the volume. Hence, in that case, the exposure system of **Fig. 1** may include a 3D scanning mode, wherein the system selects one or more scanning beams of a wavelength that does not affect the photopolymerizable medium. During the scanning process, the surface of the 3D object is scanned and either the reflected or transmitted light is detected by the imaging system of the system. The imaging system may include one or more camera sensors arranged around the reservoir so that the system is able to detect reflections of the scanning beams from different viewing angles. The captured images may be used to reconstruct the surface of the 3D object in the reservoir.

The computed reconstructed surface of the 3D object may be matched with a known 3D model to determine its orientation. To that end, a known registration method, e.g. a rigid surface registration method, may be used to register the reconstructed surface with the 3D model. This way, the orientation of the target zone can be aligned with orientation of the 3D object in the target zone. The orientation of the target zone and the computed absorptivity $\mu(x,y,z)$ may be used to calculate the optimal illumination intensity $I_0(r, \theta, z)$ to deposit around an external object using the methods described in this application.

**Fig. 7** depicts a flow diagram of a method for determining an illumination field $I_0(r,\theta,z)$ for a target polymerization zone.

In particular, **Fig. 7** depicts a flow diagram of a method for determining an illumination energy based on an iterative approach for media with a moderate absorptivity according to an embodiment of the invention. In such iterative approach, an approximated solution for an illumination intensity may be computed for each direction through an iterative minimization of an objective function that describes the discrepancy between a target energy field $E_0(x, y, z)$ and a predicted deposited energy field $E(x,y,z) = t \cdot \mathcal{M}\left[I_0(r,\theta,z)\right]$.

A propagation operator $\mathcal{M}$ may be used for predicting the energy deposition. For example, a propagation operator based on the adjoint Radon transform as described with reference to **Fig. 5** may be used. Such adjoint Radon transform uses a propagation model with an absorptivity term and assumes that photons propagate along straight lines in a parallel fashion. It may be replaced by more accurate models (for instance Radiative Transport Equations) in situations when such assumption fails. A wide range of algorithms may be used to solve the Least Squares-type minimization problem. In **Fig. 7** a basic approach is described that is applicable to cases with linear propagation model $\mathcal{M}$.

The iterative minimization method may be used once a target energy field is determined (as in step **504** of **Fig. 5)** and the output of the method may be used to control and generate direction-dependent illumination field defining a plurality of exposures of a target zone which leads to photopolymerization of the target zone (as described in set **510** of **Fig. 5**). This analytically determined illumination intensity function may be a first estimate of the illumination field that is used in the iterative minimization method (step **702**).

In a next step **704** the deposited energy field $E(x, y, z)$ is predicted. In an embodiment, the predicted energy may be computed using a modified adjoint Radon transform with an absorptivity term represented by a linear operator $\mathcal{M}$. This modified adjoint Radon transform $\mathcal{R}^*$ is described with reference to eq. (28)-(30) above.

In the following step, **708** a gradient should be computed for an objective function based on the difference between the predicted and the target energy. If the objective function is of an L2-type (Euclidian distance) the gradient as computed by applying $\mathcal{M}^*$ i.e. an adjoint version of the linear operator $\mathcal{M}$, to the difference $E(x,y,z) - E_0(x,y, z)$. An update of the current guess of the illumination field $I_0 (r, \theta, z)$ is computed by subtracting the calculated gradient of the objective function scaled by a constant factor $\alpha$. The result of this operation is the new guess of the illumination intensity function $I_0(r, \theta, z)$ **710**.

Different stopping conditions **712** can be implemented. For instance, to stop when the sum of squares of the discrepancy $E(x,y,z) - E_0(x,y,z)$ is lower than some small constant $\varepsilon$. If the condition is not satisfied a new iteration of the method is started by substitution of the updated illumination intensity function $I_0(r, \theta, z)$ **710** into step **704.** If it is satisfied, the current guess of the illumination intensity may be used to control the illumination system **714**. Also in this case, the target energy field and the intensity field may be described based on coordinate systems that are suitable for a particular case.

**Fig. 8A-8D** depict examples of computed energy deposition for a 3D object based on the iterative approach for media with moderate absorptivity. **Fig**. **8A** depicts a computed deposited energy field in a high absorptivity medium ($\mu$ = 5cm$^{-1}$) for a Yin Yang shaped object. **Fig. 8B** depicts the target energy field. **Fig. 8C** represents a cross-section through the mid-line **802** of **Fig. 8A,** wherein the solid line represents the profile of the target energy and wherein the dashed line represents the actual deposited energy. The images depicted in these figures are formed by 314 beams of 100 rays each. **Fig. 8D** shows the illumination field intensity profile for one of the directions of illumination, wherein the solid line represents the intensity profile precomputed using the analytical solution for the weak absorptivity model and the dashed line represents the intensity profile precomputed using an iterative approach applied to the model with significant absorptivity. When the absorptivity of the medium is high (or the size of the volume is too large), the approach based on the model for a weak absorptivity medium delivers poorer contrast and eventually fails. In that case, an iterative approach may be used to determine the illumination intensity. This approach is described above with a reference to **Fig. 7.**

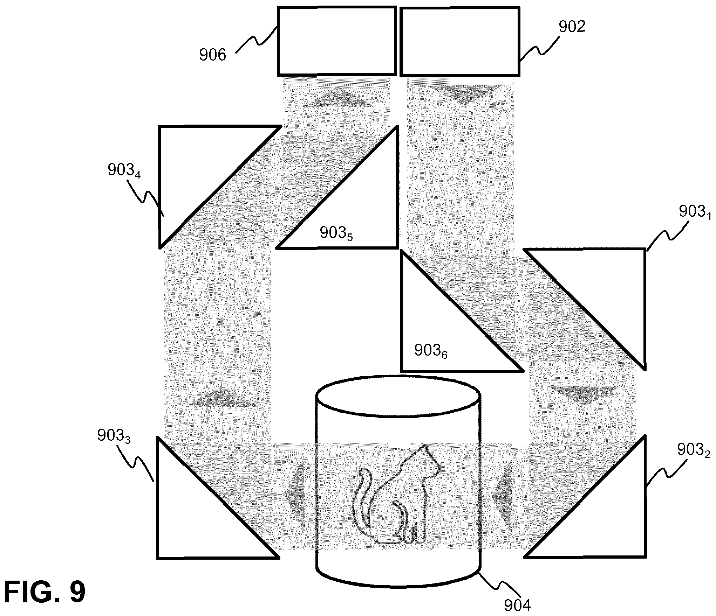

**Fig. 9** depicts a schematic of a system for forming a 3D object using photopolymerization according to an embodiment of the invention. **Fig. 9** shows a schematic of an illumination system wherein the illumination sources **902** and cameras **906** remain stationary, while moving mirrors **903$_1$-903$_6$** ensure positioning of the illumination beam during exposure. Different variations of this concept can be realized using mirrors or other light guiding systems. If the viscosity of the medium allows, the container itself **904** can be rotated, while the illumination system remains stationary.

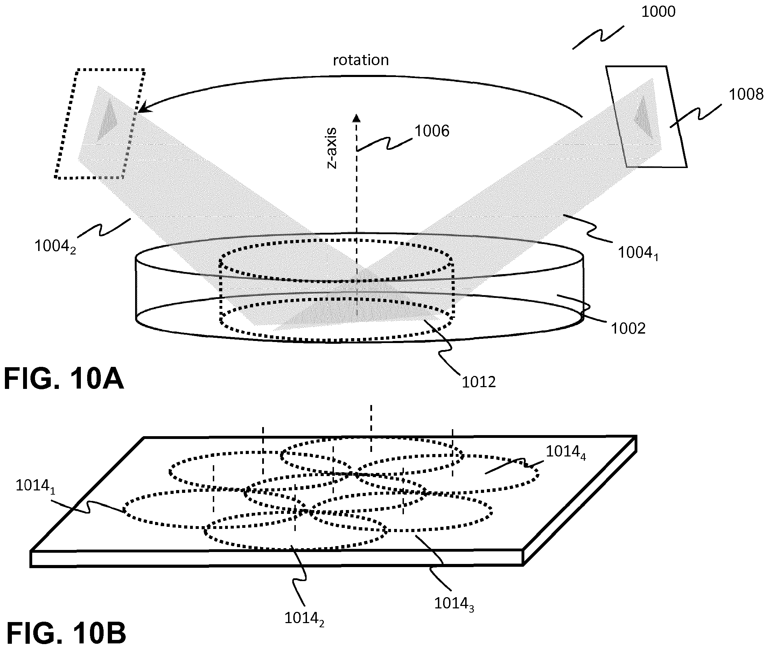

In further embodiments, the illumination system may deviate from the standard tomographic geometry as depicted in **Fig. 1** wherein light beams are projected at a 90 degree angle to the rotation axis, e.g. the z-axis. A possible implementation of such illumination system is depicted in **Fig. 10**. As shown in this figure, an illumination system may be rotatable mounted above a reservoir **1002** comprising a photopolymerizable medium. In this example, the dimensions of the reservoir in the x,y direction (perpendicular to the rotation axis **1006** of the illumination system) are substantially larger than the dimensions of the reservoir in the z direction (parallel to the rotation axis). This way, the reservoir may define one or more shallow planar-shaped target zones similar to an illumination system as used in laminography, which is a subtype of tomography.

The illumination system may comprise one or more optical elements **1008** for projecting one or more light beams from the top (or bottom) at a grazing angle $\Theta$ to the flat surface of the reservoir (wherein the angle between the one or more light beams and the rotation axis is smaller than 90 degrees). While rotating, the illumination system exposes the photopolymerizable medium in a target zone **1012** in the reservoir.

As shown in **Fig. 10B,** the illumination center of the rotation can be moved in a direction perpendicular to the rotation axis. Hence, each time the illumination system has exposed an area, the rotational axis of the illumination system is moved relative to the reservoir so that an area next to the exposed area can be exposed. This process can be repeated many times so that multiple target zones **1014$_{1-4}$** may define a large exposed area. Hence, by moving the illumination system relative to the reservoir in the x-y plane, the illumination system effectively exposes a large area of the planar reservoir. The same computational approach as for a standard geometry (e.g. as depicted in **Fig. 1**) may be used for this method as long as the light propagation direction is accounted for. While this embodiment may yield lower vertical resolution, it can be advantageous when printing has to be realized across the surface of a planar reservoir.

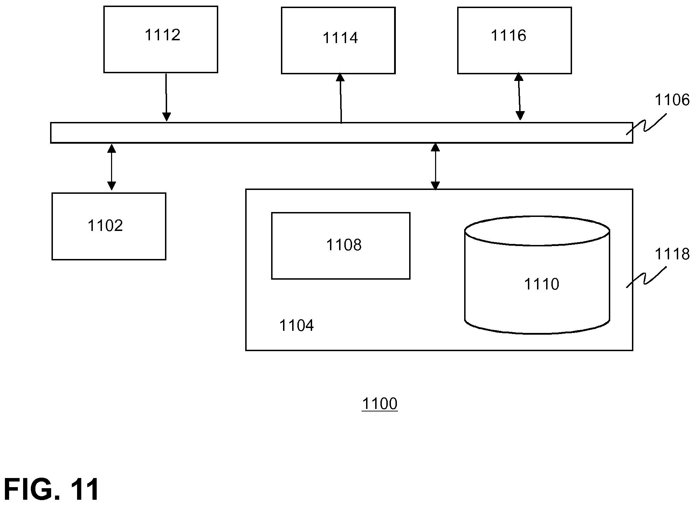

**Fig. 11** is a block diagram illustrating an exemplary data processing system that may be used in as described in this disclosure. Data processing system **1100** may include at least one processor **1102** coupled to memory elements **1104** through a system bus **1106**. As such, the data processing system may store program code within memory elements **1104**. Further, processor **1102** may execute the program code accessed from memory elements **1104** via system bus **1106**. In one aspect, data processing system may be implemented as a computer that is suitable for storing and/or executing program code. It should be appreciated, however, that data processing system **1100** may be implemented in the form of any system including a processor and memory that is capable of performing the functions described within this specification.

Memory elements **1104** may include one or more physical memory devices such as, for example, local memory **1108** and one or more bulk storage devices **1110**. Local memory may refer to random access memory or other non-persistent memory device(s) generally used during actual execution of the program code. A bulk storage device may be implemented as a hard drive or other persistent data storage device. The processing system **1100** may also include one or more cache memories (not shown) that provide temporary storage of at least some program code in order to reduce the number of times program code must be retrieved from bulk storage device **1110** during execution.

Input/output (I/O) devices depicted as input device **1012** and output device **1114** optionally can be coupled to the data processing system. Examples of input device may include, but are not limited to, for example, a keyboard, a pointing device such as a mouse, or the like. Examples of output device may include, but are not limited to, for example, a monitor or display, speakers, or the like. Input device and/or output device may be coupled to data processing system either directly or through intervening I/O controllers. A network adapter **1116** may also be coupled to data processing system to enable it to become coupled to other systems, computer systems, remote network devices, and/or remote storage devices through intervening private or public networks. The network adapter may comprise a data receiver for receiving data that is transmitted by said systems, devices and/or networks to said data and a data transmitter for transmitting data to said systems, devices and/or networks. Modems, cable modems, and Ethernet cards are examples of different types of network adapter that may be used with data processing system **1150.**

As pictured in **FIG.** 11, memory elements **1104** may store an application **1118**. It should be appreciated that data processing system **1100** may further execute an operating system (not shown) that can facilitate execution of the application. Application, being implemented in the form of executable program code, can be executed by data processing system **1100,** e.g., by processor **1102**. Responsive to executing application, data processing system may be configured to perform one or more operations to be described herein in further detail.

In one aspect, for example, data processing system **1100** may represent a client data processing system. In that case, application **1118** may represent a client application that, when executed, configures data processing system **1100** to perform the various functions described herein with reference to a "client". Examples of a client can include, but are not limited to, a personal computer, a portable computer, a mobile phone, or the like. In another aspect, data processing system may represent a server. For example, data processing system may represent an (HTTP) server in which case application **1118,** when executed, may configure data processing system to perform (HTTP) server operations. In another aspect, data processing system may represent a module, unit or function as referred to in this specification.

While the invention has been described in detail and with reference to specific embodiments thereof, it will be apparent to one of ordinary skill in the art that various changes and modifications can be made therein insofar as not departing from the scope of the claims.

## Claims

1.  Method of controlled polymerization of a target zone (124) in a photopolymerizable medium comprising:

    a processor connectable to an exposure system for illuminating the target zone in the photopolymerizable medium receiving a data representation (114) of a 3D model of an object (122) and using the 3D model to determine volume elements (120) of the target zone, the photopolymerizable medium including a photo-activation compound for activating polymerization of the medium based on a first illumination field $I_+$ of a first wavelength and a photo-deactivation compound for deactivating the polymerization in the medium based on a second illumination field $I_-$ of a second wavelength;

    the processor determining a target energy field $E_0$, the target energy field $E_0$ defining an energy to be absorbed by the volume elements of the target zone to achieve polymerization inside the target zone, the determining by the processor being based on a polymerization model $\mathcal{P}$ of the polymerization process in the medium;

    the processor computing a direction-dependent illumination field $I_0$ for depositing within an exposure time t the target energy field $E_0$ in the volume elements of the medium, the computing of $I_0$ including using a light propagation model $\mathcal{M}$ for an attenuating medium to compute the first illumination field $I_+$ for depositing within the exposure time t a first deposited energy $E_+$ in the volume elements for activating and maintaining polymerization and the second illumination field $I_-$ for depositing within the exposure time t a second deposited energy $E_-$ in the volume elements for deactivation of the polymerization;

    the processor controlling the exposure system based on the direction-dependent illumination field $I_o$, the exposure including generating a plurality of direction-dependent illumination beams to deposit energy within the volume elements of the medium according to the target energy field $E_0$.

2.  Method according to claim 1 wherein computing a direction-dependent illumination field $I_o$ further includes:

    determining a solution $I_0$ for a system of equations of the type: $E_0 = t \cdot \mathcal{M}[I_o]$ , preferably the light propagation model $\mathcal{M}$ being a model for predicting the deposited energy field $E$ in an attenuating medium.

3.  Method according to claims 1 or 2 wherein computing a direction-dependent illumination field $I_o$ further includes:

    iteratively computing an approximate solution $I_o$ based on the light propagation model $\mathcal{M}$, the computing including minimizing a difference between the target energy field $E_0$ and a deposited energy field E predicted by the light propagation model; or,

    iteratively computing an approximate solution $I_0$ based on the polymerization model $\mathcal{P}[E]$ and the light propagation model $\mathcal{M}[I_0]$, the computing including minimizing a difference between the target monomer conversion

$\mathcal{P}_0$ and a monomer conversion $\mathcal{P}[E]$ achieved due to the deposited energy field E predicted by the light propagation model $\mathcal{M}[I_0]$.

4. Method according to any of claims 1-3 wherein the polymerization model $\mathcal{P}$ is a linear approximation of the type: $E_0 = E_+ - \beta \cdot E_-$ wherein $\beta$ is a proportionality constant and wherein $E_0 > E_{crit}$ inside the target zone and $E_0 < E_{crit}$ outside the target zone and $E_{crit}$ being a critical energy needed to achieve polymerization; and/or, wherein $E_0$ is determined based on a polymerization model $\mathcal{P}[E_0] = \mathcal{P}_0$, wherein $\mathcal{P}_0$ is a target monomer conversion in a volume element, preferably the polymerization model $\mathcal{P}$ being based on reaction rate equations, a reactive force field approach, a random graph approach or a linearized approximation of these models.

5. Method according to any of claims 1-4 wherein generating a plurality of direction-dependent illumination beams includes:
the processor controlling a rotatable and/or movable illumination system, the illumination system including at least one spatial light modulator for generating the plurality of direction-dependent illumination beams.

6. Method according to any of claims 1-5 the method further comprising:

the processor controlling a detection system (112) to measure the intensity of a part of the plurality of illumination beams that was not absorbed by the medium, preferably the processor using the intensity of the part of the plurality of illumination beams that was not absorbed to compute the absorptivity of the medium $\mu$ during exposure; and, optionally,
recomputing the direction-dependent optimal illumination field $I_o$ based on the target energy field $E_0$, the light propagation model $\mathcal{M}$ and the computed absorptivity $\mu$ of the medium; and, controlling the exposure system based on the recomputed optimal direction-dependent illumination field $I_o$.

7. Method according to any of claims 1-6 wherein the system for illuminating a target zone comprises a container comprising the photopolymerizable medium and a rotatable and/or movable illumination system, the illumination system including an optical system comprising one or more light sources (106) and optical elements (108), light modulating apertures (110) and a support structure including motors and/or actuators (102) configured to rotate and/or move the illumination system around the container while locally exposing the medium to light of one or more predetermined wavelengths.

8. Method according to any of claims 1-7 wherein exposure system for illuminating a target zone further includes a 3D scanning system, wherein the determination of the volume elements of the target zone comprise:

using the 3D scanning system to determine a 3D surface representation of a physical object that is positioned in the medium;
aligning an orientation of the 3D model with the orientation of the 3D surface representation;
using the aligned 3D model and the 3D surface representation to determine the volume elements around the physical object, the volume elements defining the target zone.

9. Method of controlled polymerization of a target zone (124) in a photopolymerizable medium comprising:

a processor connectable to an exposure system for illuminating the target zone in the photopolymerizable medium in a transparent container receiving a data representation of a 3D model of an object (122) and using the 3D model to determine volume elements (120) of the target zone, the volume defined by the volume elements in the medium being shaped according to the 3D model;
the processor determining a target energy field $E_0$, the target energy field $E_0$ defining an energy to be absorbed by the volume elements of the target zone to achieve polymerization inside the target zone, the determining by the processor being based on a polymerization model $\mathcal{P}$ of the polymerization process in the medium;
the processor computing a direction-dependent illumination field $I_o$ for depositing within an exposure time $t$ the target energy field $E_0$ in the volume elements of the medium, the computing being based on a light propagation model $\mathcal{M}$ configured to predict the deposited energy field $E$ in an attenuating medium, the deposited energy field $E$ being generated upon exposure of the volume elements of the target zone to the direction-dependent illumination field $I$ during the exposure time $t$;

the processor controlling the exposure system based on the direction-dependent illumination field $I_o$, the exposure including generating a plurality of direction-dependent illumination beams to deposit energy within the volume elements of the medium according to the target energy field $E_0$; and,

the processor controlling an imaging system (112) comprising one or more camera sensors arranged to capture images of the medium and determining changes of the medium, e.g. absorptivity or refraction index, during exposure based on the captured images, preferably the changes of the medium being determined based on a phase-contrast imaging technique.

**10.** An exposure system adapted to photopolymerize a target zone (124) in a photopolymerizable medium comprising:
a computer connectable to a rotatable illumination system for exposing the photopolymerizable medium, the computer comprising a computer readable storage medium having at least part of a program embodied therewith; and a processor, preferably a microprocessor, coupled to the computer readable storage medium, wherein responsive to executing the computer readable program code, the processor is configured to perform executable operations comprising:

receiving a data representation of a 3D model of an object (122) and using the 3D model to determine volume elements (120) of the target zone, the photopolymerizable medium including a photo-activation compound for activating polymerization of the medium based on a first illumination field $I_+$ of a first wavelength and a photo-deactivation compound for deactivating the polymerization in the medium based on a second illumination field $I_-$ of a second wavelength;

determining a target energy field $E_0$, the target energy field $E_0$ defining an energy to be absorbed by the volume elements of of the target zone to achieve polymerization inside the target zone, the determining by the processor being based on a polymerization model $\mathcal{P}$ of the polymerization process in the medium;

computing a direction-dependent illumination field $I_o$ for depositing within an exposure time t the target energy field $E_0$ in the volume elements of the medium, the computing of $I_o$ including using a light propagation model $\mathcal{M}$ for an attenuating medium to compute the first illumination field $I_+$ for depositing within the exposure time t a first deposited energy $E_+$ in the volume elements for activating and maintaining polymerization and the second illumination field $I_-$ for depositing within the exposure time $t$ a second deposited energy $E_-$ in the volume elements for deactivation of the polymerization;

controlling the exposure system based on the direction-dependent illumination field $I_o$, the exposure including generating a plurality of direction-dependent illumination beams to deposit energy within the volume elements of the medium according to the target energy field $E_0$.

**11.** Exposure system according to claim 10 wherein computing a direction-dependent illumination field $I_o$ further includes:

determining a solution $I_o$ for a system of equations of the type: $E_0 = t \cdot \mathcal{M}[I_o]$, preferably the light propagation model $\mathcal{M}$ being a model for predicting the deposited energy field E in an attenuating medium.

**12.** Exposure system according to claims 10 or 11 wherein computing a direction-dependent illumination field $I_o$ further includes:

iteratively determining an approximate solution $I_o$ based on the light propagation model $\mathcal{M}$, the computing including minimizing a difference between the target energy field $E_0$ and a deposited energy field E predicted by the light propagation model $\mathcal{M}$, preferably the light propagation model $\mathcal{M}$ being a model for predicting the deposited energy field E in an attenuating medium; and/or, iteratively computing an approximate solution $I_0$ based on the polymerization model $\mathcal{P}[E]$ and the light propagation model $\mathcal{M}[I_0]$, the computing including minimizing a difference between a target monomer conversion $\mathcal{P}_0$ and a monomer conversion $\mathcal{P}[E]$ achieved due to the deposited energy field E predicted by the light propagation model $\mathcal{M}[I_0]$.

**13.** Exposure system according to any of claims 10-12 wherein the polymerization model is a linear approximation of the type: $E_0 = E_+ - \beta \cdot E_-$ wherein $\beta$ is a proportionality constant and wherein $E_0 > E_{crit}$ inside the target zone and

$E_0 < E_{crit}$ outside the target zone and $E_{crit}$ being a critical energy needed to achieve polymerization; and/or, wherein $E_0$ is determined based on a polymerization model $\mathcal{P}[E_0] = \mathcal{P}_0$, wherein $\mathcal{P}_0$ is the target monomer conversion in a volume element, preferably the polymerization model $\mathcal{P}$ being based on reaction rate equations, a reactive force field approach, a random graph approach or a (linearized) approximation of these models.

14. Exposure system according to any of claims 10-13 wherein generating a plurality of direction-dependent illumination beams includes:
the processor controlling a rotatable and/or movable illumination system, the illumination system including at least one spatial light modulator for generating the plurality of direction-dependent illumination beams.

15. Exposure system according to any of claims 10-14 the executable operations further comprising:

controlling a detection system (112) to measure the intensity of a part of the plurality of illumination beams that was not absorbed by the medium, preferably the processor using the intensity of the part of the plurality of illumination beams that was not absorbed to compute the absorptivity of the medium $\mu$ during exposure; and, optionally,

recomputing the direction-dependent illumination field $I_o$ based on the target energy field $E_0$, the light propagation model $\mathcal{M}$ and the computed absorptivity $\mu$ of the medium; and, controlling the exposure system based on the recomputed direction-dependent illumination field $I_o$.

## Patentansprüche

1. Verfahren einer kontrollierten Polymerisation einer Zielzone (124) in einem fotopolymerisierbaren Medium, das aufweist:

einen Prozessor, der mit einem Belichtungssystem zum Beleuchten der Zielzone in dem fotopolymerisierbaren Medium verbindbar ist, der eine Datendarstellung (114) eines 3D-Modells eines Objekts (122) empfängt und das 3D-Modell verwendet, um Volumenelemente (120) der Zielzone zu bestimmen, wobei das fotopolymerisierbare Medium eine Fotoaktivierungsverbindung zum Aktivieren der Polymerisation des Mediums basierend auf einem ersten Beleuchtungsfeld $I_+$ einer ersten Wellenlänge und eine Fotodeaktivierungsverbindung zum Deaktivieren der Polymerisation in dem Medium basierend auf einem zweiten Beleuchtungsfeld $I_-$ einer zweiten Wellenlänge umfasst;
wobei der Prozessor ein Zielenergiefeld $E_0$ bestimmt, wobei das Zielenergiefeld $E_0$ eine Energie definiert, die von den Volumenelementen der Zielzone aufgenommen werden soll, um die Polymerisation innerhalb der Zielzone zu erreichen, wobei die Bestimmung durch den Prozessor auf einem Polymerisationsmodell $\mathcal{P}$ des Polymerisationsverfahrens in dem Medium basiert;
wobei der Prozessor ein richtungsabhängiges Beleuchtungsfeld $I_0$ berechnet, um innerhalb einer Belichtungszeit $t$ das Zielenergiefeld $E_0$ in den Volumenelementen des Mediums abzuscheiden, wobei das Berechnen von $I_0$ die Verwendung eines Lichtausbreitungsmodells $\mathcal{M}$ für ein Dämpfungsmedium umfasst, um zu berechnen: das erste Beleuchtungsfeld $I_+$ zum Abscheiden einer ersten abgeschiedenen Energie $E_+$ in den Volumenelementen innerhalb der Belichtungszeit $t$, um die Polymerisation zu aktivieren und aufrechtzuerhalten, und das zweite Beleuchtungsfeld $I_-$ zum Abscheiden einer zweiten abgeschiedenen Energie $E_-$ in den Volumenelementen innerhalb der Belichtungszeit $t$, um die Polymerisation zu deaktivieren,
wobei der Prozessor das Belichtungssystem basierend auf dem richtungsabhängigen Beleuchtungsfeld $I_0$ steuert, wobei die Belichtung das Erzeugen mehrerer richtungsabhängiger Beleuchtungsstrahlen umfasst, um gemäß dem Zielenergiefeld $E_0$ Energie innerhalb der Volumenelemente des Mediums abzuscheiden.

2. Verfahren nach Anspruch 1, wobei das Berechnen eines richtungsabhängigen Beleuchtungsfelds $I_0$ ferner umfasst:

Bestimmen einer Lösung $I_0$ für ein Gleichungssystem des Typs: $E_0 = t \cdot \mathcal{M}[I_0]$, wobei das Lichtausbreitungsmodell $\mathcal{M}$ bevorzugt ein Modell für die Vorhersage des abgeschiedenen Energiefelds $E$ in einem Dämpfungsmedium ist.

3. Verfahren nach Anspruch 1 oder 2, wobei das Berechnen eines richtungsabhängigen Beleuchtungsfelds $I_0$ ferner umfasst:

iteratives Berechnen einer Näherungslösung $I_0$ basierend auf dem Lichtausbreitungsmodell $\mathcal{M}$, wobei die Berechnung das Minimieren einer Differenz zwischen dem Zielenergiefeld Eo und einem abgeschiedenen Energiefeld $E$, das von dem Lichtausbreitungsmodell $\mathcal{M}$ vorhergesagt wird, umfasst; oder

iteratives Berechnen einer Näherungslösung $I_0$ basierend auf dem Polymerisationsmodell $\mathcal{P}[E]$ und dem Lichtausbreitungsmodell $\mathcal{M}[I_0]$, wobei die Berechnung das Minimieren einer Differenz zwischen der Ziel-monomerumwandlung $\mathcal{P}_0$ und einer Monomerumwandlung $\mathcal{P}[E]$, die aufgrund des abgeschiedenen Energiefelds $E$, das von dem Lichtausbreitungsmodell $\mathcal{M}[I_0]$ vorhergesagt wird, umfasst.

4. Verfahren nach einem der Ansprüche 1-3, wobei das Polymerisationsmodell $\mathcal{P}$ ein lineares Näherungsmodell des Typs $E_0 = E_+ - \beta \cdot E_-$ ist, wobei $\beta$ eine Proportionalitätskonstante ist und wobei innerhalb der Zielzone $E_0 > E_{crit}$ und außerhalb der Zielzone $E_0 < E_{crit}$, wobei $E_{crit}$ eine kritische Energie ist, die benötigt wird, um die Polymerisation zu erreichen; und/oder wobei $E_0$ basierend auf einem Polymerisationsmodell $\mathcal{P}[E_0] = \mathcal{P}_0$ bestimmt wird, wobei $\mathcal{P}_0$ eine Zielmonomerumwandlung in einem Volumenelement ist, wobei das Polymerisationsmodell $\mathcal{P}$ bevorzugt auf Reaktionsratengleichungen, einem Reaktionskraftfeldansatz, einem Zufallsgraphansatz oder einer linearisierten Näherung dieser Modelle basiert.

5. Verfahren nach einem der Ansprüche 1 - 4, wobei das Erzeugen mehrerer richtungsabhängiger Beleuchtungsstrahlen umfasst:
Steuern eines drehbaren und/oder verschiebbaren Beleuchtungssystems durch den Prozessor, wobei das Beleuchtungssystem wenigstens einen räumlichen Lichtmodulator zum Erzeugen der mehreren richtungsabhängigen Beleuchtungsstrahlen umfasst.

6. Verfahren nach einem der Ansprüche 1 - 5, wobei das Verfahren ferner aufweist:

Steuern eines Detektionssystems (112) durch den Prozessor, um die Intensität eines Teils der mehreren Beleuchtungsstrahlen, die nicht durch das Medium absorbiert wurden, zu messen, wobei der Prozessor bevorzugt die Intensität des Teils der mehreren Beleuchtungsstrahlen, die nicht absorbiert wurde, verwendet, um das Absorptionsvermögen des Mediums $\mu$ während der Belichtung zu berechnen; und optional erneutes Berechnen des richtungsabhängigen optimalen Beleuchtungsfelds $I_0$ basierend auf dem Zielenergiefeld $E_0$, dem Lichtausbreitungsmodell $\mathcal{M}$ und dem berechneten Absorptionsvermögen $\mu$ des Mediums; und Steuern des Belichtungssystems basierend auf dem neu berechneten optimalen richtungsabhängigen Beleuchtungsfeld $I_0$.

7. Verfahren nach einem der Ansprüche 1 - 6, wobei das System zur Beleuchtung einer Zielzone einen Behälter, der ein fotopolymerisierbares Medium aufweist, und ein drehbares und/oder verschiebbares Beleuchtungssystem aufweist, wobei das Beleuchtungssystem umfasst: ein optisches System, das eine oder mehrere Lichtquellen (106) und optische Elemente (108) aufweist, lichtmodulierende Blenden (110) und eine Haltestruktur mit Motoren und/oder Aktuatoren (102), die konfiguriert sind, um das Beleuchtungssystem um den Behälter herum zu drehen und/oder zu bewegen, während das Medium lokal Licht mit einer oder mehreren vorgegebenen Wellenlängen ausgesetzt wird.

8. Verfahren nach einem der Ansprüche 1 - 7, wobei das Belichtungssystem zum Beleuchten einer Zielzone ferner ein 3D-Abtastsystem umfasst, wobei die Bestimmung der Volumenelemente der Zielzone aufweist:

Verwenden eines 3D-Abtastsystems, um eine 3D-Oberflächendarstellung eines physikalischen Objekts, das in dem Medium positioniert ist, zu bestimmen;
Ausrichtung einer Orientierung des 3D-Modells mit der Orientierung der 3D-Oberflächendarstellung;
Verwenden des ausgerichteten 3D-Modells und der 3D-Oberflächendarstellung, um die Volumenelemente um das physikalische Objekt herum zu bestimmen, wobei die Volumenelemente die Zielzone definieren.

9. Verfahren zur kontrollierten Polymerisation einer Zielzone (124) in einem fotopolymerisierbaren Medium, das aufweist:

einen Prozessor, der mit einem Belichtungssystem zum Beleuchten der Zielzone in dem fotopolymerisierbaren Medium in einem transparenten Behälter verbindbar ist, der eine Datendarstellung eines 3D-Modells eines Objekts (122) empfängt und das 3D-Modell verwendet, um Volumenelemente (120) der Zielzone zu bestimmen, wobei das durch die Volumenelemente in dem Medium definierte Volumen gemäß dem 3D-Modell geformt ist; wobei der Prozessor ein Zielenergiefeld $E_0$ bestimmt, wobei das Zielenergiefeld $E_0$ eine Energie definiert, die von den Volumenelementen der Zielzone absorbiert werden soll, um die Polymerisation innerhalb der Zielzone zu erreichen, wobei die Bestimmung durch den Prozessor auf einem Polymerisationsmodell $\mathcal{P}$ des Polymerisationsverfahrens in dem Medium basiert; wobei der Prozessor ein richtungsabhängiges Beleuchtungsfeld $I_0$ berechnet, um innerhalb einer Belichtungszeit $t$ das Zielenergiefeld $E_0$ in den Volumenelementen des Mediums abzuscheiden, wobei die Berechnung auf einem Lichtausbreitungsmodell $\mathcal{M}$, das konfiguriert ist, um das abgeschiedene Energiefeld $E$ in einem Dämpfungsmedium vorherzusagen, basiert, wobei das abgeschiedene Energiefeld $E$ nach Belichtung der Volumenelemente der Zielzone mit dem richtungsabhängigen Beleuchtungsfeld $I$ während der Belichtungszeit t erzeugt wird; wobei der Prozessor das Belichtungssystem basierend auf dem richtungsabhängigen Beleuchtungsfeld $I_0$ steuert, wobei die Belichtung das Erzeugen mehrerer richtungsabhängiger Beleuchtungsstrahlen umfasst, um gemäß dem Zielenergiefeld $E_0$ Energie innerhalb der Volumenelemente des Mediums abzuscheiden; und wobei der Prozessor ein Abbildungssystem (112) steuert, das eine oder mehrere Kamerasensoren aufweist, die eingerichtet sind, um Bilder des Mediums aufzunehmen und Änderungen des Mediums, z.B. des Absorptionsvermögens oder des Brechungsindex, während der Belichtung basierend auf den aufgenommenen Bildern zu bestimmen, wobei die Änderungen des Mediums bevorzugt basierend auf einem Phasenkontrast-Abbildungsverfahren bestimmt werden.

10. Belichtungssystem, das geeignet ist, eine Zielzone (124) in einem fotopolymerisierbaren Medium zu fotopolymerisieren, das aufweist:

einen Computer, der mit einem drehbaren Beleuchtungssystem zum Beleuchten des fotopolymerisierbaren Mediums verbindbar ist, wobei der Computer ein computerlesbares Speichermedium, das wenigstens einen Teil eines Programms darin ausgeführt hat, aufweist; und einen Prozessor, bevorzugt einen Mikroprozessor, der mit dem computerlesbaren Speichermedium gekoppelt ist, wobei der Prozessor konfiguriert ist, um ansprechend auf das Ausführen des computerlesbaren Programmkodes ausführbare Operationen durchzuführen, die aufweisen:

Empfangen einer Datendarstellung eines 3D-Modells eines Objekts (122) und Verwenden des 3D-Modells, um Volumenelemente (120) der Zielzone zu bestimmen, wobei das fotopolymerisierbare Medium eine Fotoaktivierungsverbindung zum Aktivieren der Polymerisation des Mediums basierend auf einem ersten Beleuchtungsfeld $I_+$ einer ersten Wellenlänge und eine Fotodeaktivierungsverbindung zum Deaktivieren der Polymerisation in dem Medium basierend auf einem zweiten Beleuchtungsfeld $I_-$ einer zweiten Wellenlänge umfasst; Bestimmen eines Zielenergiefelds $E_0$, wobei das Zielenergiefeld $E_0$ eine Energie definiert, die von den Volumenelementen der Zielzone absorbiert werden soll, um die Polymerisation innerhalb der Zielzone zu erreichen, wobei die Bestimmung durch den Prozessor auf einem Polymerisationsmodell $\mathcal{P}$ des Polymerisationsverfahrens in dem Medium basiert; Berechnen eines richtungsabhängigen Beleuchtungsfelds $I_0$, um innerhalb einer Belichtungszeit $t$ das Zielenergiefeld $E_0$ in den Volumenelementen des Mediums abzuscheiden, wobei das Berechnen von $I_0$ die Verwendung eines Lichtausbreitungsmodells $\mathcal{M}$ für ein Dämpfungsmedium umfasst, um zu berechnen: das erste Beleuchtungsfeld $I_+$ zum Abscheiden einer ersten abgeschiedenen Energie $E_+$ in den Volumenelementen innerhalb der Belichtungszeit t, um die Polymerisation zu aktivieren und aufrechtzuerhalten, und das zweite Beleuchtungsfeld $I_-$ zum Abscheiden einer zweiten abgeschiedenen Energie $E_-$ in den Volumenelementen innerhalb der Belichtungszeit $t$, um die Polymerisation zu deaktivieren; Steuern des Belichtungssystems basierend auf dem richtungsabhängigen Beleuchtungsfeld $I_0$, wobei die Belichtung das Erzeugen mehrerer richtungsabhängiger Beleuchtungsstrahlen umfasst, um gemäß dem Zielenergiefeld $E_0$ Energie innerhalb der Volumenelemente des Mediums abzuscheiden.

11. Belichtungssystem nach Anspruch 10, wobei das Berechnen eines richtungsabhängigen Beleuchtungsfelds $I_0$ ferner

umfasst:
Bestimmen einer Lösung $I_0$ für ein Gleichungssystem des Typs:

$$E_0 = t \cdot \mathcal{M}[I_0],$$

wobei das Lichtausbreitungsmodell $\mathcal{M}$ bevorzugt ein Modell für die Vorhersage des abgeschiedenen Energiefelds $E$ in einem Dämpfungsmedium ist.

12. Belichtungssystem nach Anspruch 10 oder 11, wobei das Berechnen eines richtungsabhängigen Beleuchtungsfelds $I_0$ ferner umfasst:

iteratives Berechnen einer Näherungslösung $I_0$ basierend auf dem Lichtausbreitungsmodell $\mathcal{M}$, wobei die Berechnung das Minimieren einer Differenz zwischen dem Zielenergiefeld $E_0$ und einem abgeschiedenen Energiefeld $E$, das von dem Lichtausbreitungsmodell $\mathcal{M}$ vorhergesagt wird, umfasst, wobei das Lichtausbreitungsmodell $\mathcal{M}$ bevorzugt ein Modell zur Vorhersage des abgeschiedenen Energiefelds $E$ in einem Dämpfungsmedium ist; und/oder

iteratives Berechnen einer Näherungslösung $I_0$ basierend auf dem Polymerisationsmodell $\mathcal{P}[E]$ und dem Lichtausbreitungsmodell $\mathcal{M}[I_0]$, wobei die Berechnung das Minimieren einer Differenz zwischen einer Ziel-monomerumwandlung $\mathcal{P}_0$ und einer Monomerumwandlung $\mathcal{P}[E]$, die aufgrund des abgeschiedenen Energiefelds $E$, das von dem Lichtausbreitungsmodell

$$\mathcal{M}[I_0]$$

vorhergesagt wird, umfasst.

13. Belichtungssystem nach einem der Ansprüche 10 - 12, wobei das Polymerisationsmodell ein lineares Näherungsmodell des Typs $E_0 = E_+ - \beta \cdot E_-$ ist, wobei $\beta$ eine Proportionalitätskonstante ist und wobei innerhalb der Zielzone $E_0 > E_{crit}$ und außerhalb der Zielzone $E_0 < E_{crit}$, wobei $E_{crit}$ eine kritische Energie ist, die benötigt wird, um die Polymerisation zu erreichen; und/oder wobei $E_0$ basierend auf einem Polymerisationsmodell $\mathcal{P}[E_0] = \mathcal{P}_0$ bestimmt wird, wobei $\mathcal{P}_0$ die Zielmonomerumwandlung in einem Volumenelement ist, wobei das Polymerisationsmodell $\mathcal{P}$ bevorzugt auf Reaktionsratengleichungen, einem Reaktionskraftfeldansatz, einem Zufallsgraphansatz oder einer (linearisierten) Näherung dieser Modelle basiert.

14. Belichtungssystem nach einem der Ansprüche 10 - 13, wobei das Erzeugen mehrerer richtungsabhängiger Beleuchtungsstrahlen umfasst:
Steuern eines drehbaren und/oder bewegbaren Beleuchtungssystems durch den Prozessor, wobei das Beleuchtungssystem wenigstens einen räumlichen Lichtmodulator zum Erzeugen der mehreren richtungsabhängigen Beleuchtungsstrahlen umfasst.

15. Belichtungssystem nach einem der Ansprüche 10 - 14, wobei die ausführbaren Operationen ferner aufweisen:

Steuern eines Detektionssystems (112), um die Intensität eines Teils der mehreren Beleuchtungsstrahlen, die nicht durch das Medium absorbiert wurden, zu messen, wobei der Prozessor bevorzugt die Intensität des Teils der mehreren Beleuchtungsstrahlen, die nicht absorbiert wurde, verwendet, um das Absorptionsvermögen des Mediums $\mu$ während der Belichtung zu berechnen; und optional erneutes Berechnen des richtungsabhängigen Beleuchtungsfelds $I_0$ basierend auf dem Zielenergiefeld $E_0$, dem Lichtausbreitungsmodell $\mathcal{M}$ und dem berechneten Absorptionsvermögen $\mu$ des Mediums; und Steuern des Belichtungssystems basierend auf dem neu berechneten richtungsabhängigen Beleuchtungsfeld $I_0$.

**Revendications**

1. Procédé de polymérisation contrôlée d'une zone cible (124) dans un milieu photopolymérisable comprenant :

   par un processeur pouvant être relié à un système d'exposition pour éclairer la zone cible dans le milieu photopolymérisable, la réception d'une représentation de données (114) d'un modèle 3D d'un objet (122) et l'utilisation du modèle 3D pour déterminer des éléments de volume (120) de la zone cible, le milieu photopolymérisable incluant un composé de photo-activation pour activer une polymérisation du milieu sur la base d'un premier champ d'éclairage $I_+$ d'une première longueur d'onde et un composé de photo-désactivation pour désactiver la polymérisation dans le milieu sur la base d'un second champ d'éclairage $I_-$ d'une seconde longueur d'onde ;
   par le processeur, la détermination d'un champ d'énergie cible Eo, le champ d'énergie cible Eo définissant une énergie à absorber par les éléments de volume de la zone cible pour accomplir une polymérisation dans la zone cible, la détermination par le processeur étant basée sur un modèle de polymérisation $\mathcal{P}$ du processus de polymérisation dans le milieu ;
   par le processeur, le calcul d'un champ d'éclairage dépendant de la direction $I_0$ pour déposer, au cours d'un temps d'exposition t, le champ d'énergie cible Eo dans les éléments de volume du milieu, le calcul de $I_0$ incluant l'utilisation d'un modèle de propagation de lumière $\mathcal{M}$ pour un milieu d'atténuation pour calculer le premier champ d'éclairage $I_+$ pour déposer, au cours du temps d'exposition t, une première énergie déposée E+ dans les éléments de volume pour activer et maintenir une polymérisation et le second champ d'éclairage $I_-$ pour déposer, au cours du temps d'exposition t, une seconde énergie déposée E_ dans les éléments de volume pour une désactivation de la polymérisation ;
   par le processeur, le contrôle du système d'exposition sur la base du champ d'éclairage dépendant de la direction $I_0$, l'exposition incluant la génération d'une pluralité de faisceaux d'éclairage dépendant de la direction pour déposer une énergie à l'intérieur des éléments de volume du milieu en fonction du champ d'énergie cible Eo.

2. Procédé selon la revendication 1, dans lequel le calcul d'un champ d'éclairage dépendant de la direction $I_0$ inclut en outre :
   la détermination d'une solution $I_0$ pour un système d'équations du type : $E_0 =$

   $$t.\mathcal{M}[I_0],$$

   de préférence le modèle de propagation de lumière $\mathcal{M}$ étant un modèle pour prédire le champ d'énergie déposée E dans un milieu d'atténuation.

3. Procédé selon la revendication 1 ou 2, dans lequel le calcul d'un champ d'éclairage dépendant de la direction $I_0$ inclut en outre :

   le calcul itératif d'une solution approximative $I_0$ sur la base du modèle de propagation de lumière $\mathcal{M}$, le calcul incluant la minimisation d'une différence entre le champ d'énergie cible Eo et un champ d'énergie déposée E prédit par le modèle de propagation de lumière ; ou
   le calcul itératif d'une solution approximative $I_0$ sur la base du modèle de polymérisation $\mathcal{P}[E]$ et du modèle de propagation de lumière

   $$\mathcal{M}[I_0],$$

   le calcul incluant la minimisation d'une différence entre la conversion de monomère cible $\mathcal{P}_0$ et une conversion de monomère $\mathcal{P}[E]$ accomplie en raison du champ d'énergie déposée E prédit par le modèle de propagation

de lumière

$$\mathcal{M}[I_0].$$

**4.** Procédé selon l'une quelconque des revendications 1 à 3, dans lequel le modèle de polymérisation $\mathcal{P}$ est une approximation linéaire du type : $E_0 = E_+ - \beta. E_-$, dans lequel $\beta$ est une constante de proportionnalité et dans lequel $E_0 > E_{crit}$ à l'intérieur de la zone cible et $E_0 < E_{crit}$ à l'extérieur de la zone cible et $E_{crit}$ étant une énergie critique nécessaire pour accomplir une polymérisation ; et/ou dans lequel Eo est déterminé sur la base d'un modèle de polymérisation $\mathcal{P}[E_0] = \mathcal{P}_0$, dans lequel $\mathcal{P}_0$ est une conversion de monomère cible dans un élément de volume, de préférence le modèle de polymérisation $\mathcal{P}$ étant basé sur des équations de vitesse de réaction, une approche de champ de force réactive, une approche de graphe aléatoire ou une approximation linéarisée de ces modèles.

**5.** Procédé selon l'une quelconque des revendications 1 à 4, dans lequel la génération d'une pluralité de faisceaux d'éclairage dépendant de la direction inclut :
par le processeur, le contrôle d'un système d'éclairage rotatif et/ou mobile, le système d'éclairage incluant au moins un modulateur spatial de lumière pour générer la pluralité de faisceaux d'éclairage dépendant de la direction.

**6.** Procédé selon l'une quelconque des revendications 1 à 5, le procédé comprenant en outre :

par le processeur, le contrôle d'un système de détection (112) pour mesurer l'intensité d'une partie de la pluralité de faisceaux d'éclairage qui n'a pas été absorbée par le milieu, de préférence le processeur utilisant l'intensité de la partie de la pluralité de faisceaux d'éclairage qui n'a pas été absorbée pour calculer l'absorptivité $\mu$ du milieu au cours d'une exposition ; et facultativement
le recalcul du champ d'éclairage optimal dépendant de la direction $I_0$ sur la base du champ d'énergie cible Eo, du modèle de propagation de lumière $\mathcal{M}$ et de l'absorptivité $\mu$ calculée du milieu ; et le contrôle du système d'exposition sur la base du champ d'éclairage dépendant de la direction optimal recalculé $I_0$.

**7.** Procédé selon l'une quelconque des revendications 1 à 6, dans lequel le système d'éclairage d'une zone cible comprend un contenant comprenant le milieu photopolymérisable et un système d'éclairage rotatif et/ou mobile, le système d'éclairage incluant un système optique comprenant une ou plusieurs sources de lumière (106) et des éléments optiques (108), des ouvertures de modulation de lumière (110) et une structure de support incluant des moteurs et/ou des actionneurs (102) configurés pour faire tourner et/ou déplacer le système d'éclairage autour du contenant tout en exposant localement le milieu à une lumière d'une ou plusieurs longueurs d'onde prédéterminées.

**8.** Procédé selon l'une quelconque des revendications 1 à 7, dans lequel un système d'exposition pour éclairer une zone cible inclut en outre un système de balayage 3D, dans lequel la détermination des éléments de volume de la zone cible comprend :

l'utilisation du système de balayage 3D pour déterminer une représentation de surface 3D d'un objet physique qui est positionné dans le milieu ;
l'alignement d'une orientation du modèle 3D avec l'orientation de la représentation de surface 3D ;
l'utilisation du modèle 3D aligné et de la représentation de surface 3D pour déterminer les éléments de volume autour de l'objet physique, les éléments de volume définissant la zone cible.

**9.** Procédé de polymérisation contrôlée d'une zone cible (124) dans un milieu photopolymérisable comprenant :

par un processeur pouvant être relié à un système d'exposition pour éclairer la zone cible dans le milieu photopolymérisable dans un contenant transparent, la réception d'une représentation de données d'un modèle 3D d'un objet (122) et l'utilisation du modèle 3D pour déterminer des éléments de volume (120) de la zone cible, le volume défini par les éléments de volume dans le milieu étant façonné selon le modèle 3D ;
par le processeur, la détermination d'un champ d'énergie cible Eo, le champ d'énergie cible Eo définissant une énergie à absorber par les éléments de volume de la zone cible pour accomplir une polymérisation dans la zone cible, la détermination par le processeur étant basée sur un modèle de polymérisation $\mathcal{P}$ du processus

de polymérisation dans le milieu ;

par le processeur, le calcul d'un champ d'éclairage dépendant de la direction $I_0$ pour déposer, au cours d'un temps d'exposition t, le champ d'énergie cible Eo dans les éléments de volume du milieu, le calcul étant basé sur un modèle de propagation de lumière $\mathcal{M}$ configuré pour prédire le champ d'énergie déposée E dans un milieu d'atténuation, le champ d'énergie déposée E étant généré lors d'une exposition des éléments de volume de la zone cible au champ d'éclairage dépendant de la direction I au cours du temps d'exposition t ;

par le processeur, le contrôle du système d'exposition sur la base du champ d'éclairage dépendant de la direction $I_0$, l'exposition incluant la génération d'une pluralité de faisceaux d'éclairage dépendant de la direction pour déposer une énergie à l'intérieur des éléments de volume du milieu en fonction du champ d'énergie cible $E_0$ ; et

par le processeur, le contrôle d'un système d'imagerie (112) comprenant un ou plusieurs capteurs de caméra agencés pour capturer des images du milieu et la détermination de changements du milieu, par exemple une absorptivité ou un indice de réfraction, au cours d'une exposition sur la base des images capturées, de préférence les changements du milieu étant déterminés sur la base d'une technique d'imagerie à contraste de phase.

10. Système d'exposition apte à photopolymériser une zone cible (124) dans un milieu photopolymérisable comprenant :
un ordinateur pouvant être relié à un système d'éclairage rotatif pour exposer le milieu photopolymérisable, l'ordinateur comprenant un support de stockage lisible par ordinateur comportant au moins une partie d'un programme incorporée à celui-ci ; et un processeur, de préférence un microprocesseur, couplé au support de stockage lisible par ordinateur, dans lequel, en réponse à l'exécution du code de programme lisible par ordinateur, le processeur est configuré pour réaliser des opérations exécutables comprenant :

la réception d'une représentation de données d'un modèle 3D d'un objet (122) et l'utilisation du modèle 3D pour déterminer des éléments de volume (120) de la zone cible, le milieu photopolymérisable incluant un composé de photo-activation pour activer une polymérisation du milieu sur la base d'un premier champ d'éclairage $I_+$ d'une première longueur d'onde et un composé de photo-désactivation pour désactiver la polymérisation dans le milieu sur la base d'un second champ d'éclairage $I_-$ d'une seconde longueur d'onde ;

la détermination d'un champ d'énergie cible Eo, le champ d'énergie cible Eo définissant une énergie à absorber par les éléments de volume de la zone cible pour accomplir une polymérisation dans la zone cible, la détermination par le processeur étant basée sur un modèle de polymérisation $\mathcal{P}$ du processus de polymérisation dans le milieu ;

le calcul d'un champ d'éclairage dépendant de la direction $I_0$ pour déposer, au cours d'un temps d'exposition t, le champ d'énergie cible Eo dans les éléments de volume du milieu, le calcul de $I_0$ incluant l'utilisation d'un modèle de propagation de lumière $\mathcal{M}$ pour un milieu d'atténuation pour calculer le premier champ d'éclairage $I_+$ pour déposer, au cours du temps d'exposition t, une première énergie déposée E+ dans les éléments de volume pour activer et maintenir une polymérisation et le second champ d'éclairage $I_-$ pour déposer, au cours du temps d'exposition t, une seconde énergie déposée E_ dans les éléments de volume pour une désactivation de la polymérisation ;

le contrôle du système d'exposition sur la base du champ d'éclairage dépendant de la direction $I_0$, l'exposition incluant la génération d'une pluralité de faisceaux d'éclairage dépendant de la direction pour déposer une énergie à l'intérieur des éléments de volume du milieu en fonction du champ d'énergie cible Eo.

11. Système d'exposition selon la revendication 10, dans lequel le calcul d'un champ d'éclairage dépendant de la direction $I_0$ inclut en outre :
la détermination d'une solution $I_0$ pour un système d'équations du type : $E_0 =$

$$t.\mathcal{M}[I_0],$$

de préférence le modèle de propagation de lumière $\mathcal{M}$ étant un modèle pour prédire le champ d'énergie déposée E dans un milieu d'atténuation.

12. Système d'exposition selon la revendication 10 ou 11, dans lequel le calcul d'un champ d'éclairage dépendant de la direction $I_0$ inclut en outre :
la détermination itérative d'une solution approximative $I_0$ sur la base du modèle de propagation de lumière $\mathcal{M}$, le

calcul incluant la minimisation d'une différence entre le champ d'énergie cible Eo et un champ d'énergie déposée E prédit par le modèle de propagation de lumière $\mathcal{M}$, de préférence le modèle de propagation de lumière $\mathcal{M}$ étant un modèle pour prédire le champ d'énergie déposée E dans un milieu d'atténuation ; et/ou le calcul itératif d'une solution approximative $I_0$ sur la base du modèle de polymérisation $\mathcal{P}[E]$ et du modèle de propagation de lumière

$$\mathcal{M}[I_0],$$

le calcul incluant la minimisation d'une différence entre une conversion de monomère cible $\mathcal{P}_0$ et une conversion de monomère $\mathcal{P}[E]$ accomplie en raison du champ d'énergie déposée E prédit par le modèle de propagation de lumière

$$\mathcal{M}[I_0].$$

13. Système d'exposition selon l'une quelconque des revendications 10 à 12, dans lequel le modèle de polymérisation est une approximation linéaire du type : $E_0 = E_+ - \beta . E_-$, dans lequel $\beta$ est une constante de proportionnalité et dans lequel $E_0 > E_{crit}$ à l'intérieur de la zone cible et $E_0 < E_{crit}$ à l'extérieur de la zone cible et $E_{crit}$ étant une énergie critique nécessaire pour accomplir une polymérisation ; et/ou dans lequel $E_0$ est déterminé sur la base d'un modèle de polymérisation $\mathcal{P}[E_0] = \mathcal{P}_0$, dans lequel $\mathcal{P}_0$ est la conversion de monomère cible dans un élément de volume, de préférence le modèle de polymérisation $\mathcal{P}$ étant basé sur des équations de vitesse de réaction, une approche de champ de force réactive, une approche de graphe aléatoire ou une approximation (linéarisée) de ces modèles.

14. Système d'exposition selon l'une quelconque des revendications 10 à 13, dans lequel la génération d'une pluralité de faisceaux d'éclairage dépendant de la direction inclut :
par le processeur, le contrôle d'un système d'éclairage rotatif et/ou mobile, le système d'éclairage incluant au moins un modulateur spatial de lumière pour générer la pluralité de faisceaux d'éclairage dépendant de la direction.

15. Système d'exposition selon l'une quelconque des revendications 10 à 14, les opérations exécutables comprenant en outre :

le contrôle d'un système de détection (112) pour mesurer l'intensité d'une partie de la pluralité de faisceaux d'éclairage qui n'a pas été absorbée par le milieu, de préférence le processeur utilisant l'intensité de la partie de la pluralité de faisceaux d'éclairage qui n'a pas été absorbée pour calculer l'absorptivité $\mu$ du milieu au cours d'une exposition ; et facultativement
le recalcul du champ d'éclairage optimal dépendant de la direction $I_0$ sur la base du champ d'énergie cible Eo, du modèle de propagation de lumière $\mathcal{M}$ et de l'absorptivité $\mu$ calculée du milieu ; et le contrôle du système d'exposition sur la base du champ d'éclairage dépendant de la direction optimal recalculé $I_0$.

**FIG. 1**

EP 3 857 309 B1

FIG. 2

FIG. 3A

FIG. 3B

EP 3 857 309 B1

FIG. 3C

FIG. 3D

FIG. 3E

FIG. 4A

FIG. 4B

FIG. 4C

FIG. 4D

a processor connectable to an exposure system for illuminating a target zone in a polymerizable medium receiving a 3D data representation of a 3D model of an object and using the 3D model to determine a volume of the target zone, the volume being shaped according to the 3D model

502

the processor determining a target energy field $E_0$ defining an energy for volume elements in the medium that is needed to achieve polymerization inside the target zone, the determining being based on a model $\mathcal{P}[E]$ of the polymerization process in the medium

504

the processor using the target energy field $E_0$ and a light propagation model $\mathcal{M}$ for an attenuating medium to compute a solution $I_o$ for the equation $E_0 = t \cdot \mathcal{M}[I_o]$ wherein $I_o$ is a direction-dependent illumination field for achieving energy deposition in the medium according to the target energy field $E_0$ and $t$ is the exposure time

506

the processor controlling the exposure system based on the direction-dependent illumination field $I_o$, the exposure including generating a plurality of direction-dependent illumination beams to deposit energy within the target zone according to the target energy field $E_0$

508

FIG. 5

FIG. 6A

FIG. 6B

FIG. 6C

FIG. 6D

EP 3 857 309 B1

EP 3 857 309 B1

a computer connectable to an exposure system for illuminating a target zone in a polymerizable medium receiving a 3D data representation of a 3D model of an object and using the 3D model to determine a volume of the target zone, the volume being shaped according to the 3D model, the computer determining a target energy field $E_0$ defining an energy for volume elements in the medium that is needed to achieve polymerization inside the target zone                702

703    determining an initial guess for a direction-dependent illumination field $I_0$ for achieving energy deposition in the medium according to the target energy field, the determining being based model of the polymerization process in the medium

704    computing a predicted deposited energy field $E$ using a light propagation model $\mathcal{M}$ with attenuation: $E = t \cdot \mathcal{M} I_0$, where $\mathcal{M} = \mu \cdot \tilde{\mathcal{R}}^*$

708    computing an update $I'_0$ the direction dependent illuminationfield based on a difference between the predicted deposited energy field and a target energy field: $I'_0 = I_0 - \alpha \cdot \mathcal{M}^* (E - E_0)$ wherein· $\mathcal{M}^*$ is an adjoint version of $\mathcal{M}$

710            setting new illumination intensity field $I_0 = I'_0$

NO

712  stopping criterion: e.g., $\sum (E - E_0)^2 < \epsilon$

YES

714    the computer controlling the exposure system based on the direction-dependent illumination field $I_o$, the exposure including generating a plurality of direction-dependent illumination beams to deposit energy within the target zone according to the target energy field $E_0$

**FIG. 7**

**FIG. 8A**

**FIG. 8B**

**FIG. 8C**

**FIG. 8D**

FIG. 9

**FIG. 10A**

**FIG. 10B**

FIG. 11

EP 3 857 309 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018086007 A

**Non-patent literature cited in the description**

- One-step volumetric additive manufacturing of complex polymer structures. *Science Advances,* 08 December 2017, vol. 3 (12
- **BRETT E. KELLY.** Computed Axial Lithography (CAL): Toward Single Step 3D Printing of Arbitrary Geometries. *arXiv,* May 2017
- **TORRES-KNOOP, A et al.** *Soft matter,* 2018, vol. 14.17, 3404-3414
- **KRYVEN, I.** *Phys. Rev. E,* 2016, vol. 94.1, 012315
- **KRYVEN, I.** *J Math Chem,* 2018, vol. 56, 140
- One-step volumetric additive manufacturing of complex polymer structures. *Science Advances,* 08 December 2017, vol. 3
- **HERMAN, G. T.** Fundamentals of computerized tomography: Image re-construction from projection. Springer, 2009
- *Nature Methods,* 2013, vol. 10, 861864